# FASCICULE DE BREVET EUROPEEN

(11) **EP 1 435 006 B1**
(45) Date de publication et mention de la délivrance du brevet: **06.12.2006**
(21) Numéro de dépôt: 02785524.6
(22) Date de dépôt: 07.10.2002
(51) Int. Cl.: G01R 33/09

(54) **STRUCTURE POUR CAPTEUR ET CAPTEUR DE CHAMP MAGNETIQUE**
SENSORSTRUKTUR UND MAGNETFELDSENSOR
SENSOR STRUCTURE AND MAGNETIC FIELD SENSOR

(30) Priorité: 09.10.2001 FR 0112956
(43) Date de publication de la demande: 07.07.2004
(73) Titulaire: COMMISSARIAT A L'ENERGIE ATOMIQUE, 75015 Paris (FR)
(72) Inventeur: BARAGATTI, Claire, F-38450 Le Gua (FR); CUCHET, Robert, F-38000 Grenoble (FR); VIEUX-ROCHAZ, Line, F-38360 Sassenage (FR)
(74) Mandataire: Poulin, Gérard
(86) Numéro de dépôt international: PCT/FR2002/003407
(87) Numéro de publication internationale: WO 2003/032001

(56) Documents cités:
- FR-A- 2 775 772
- US-A- 6 066 947
- US-A- 6 075 361
- KU WANJUN ET AL: "Precision X-Y robotic object handling using a dual GMR bridge sensor" 2000 IEEE INTERNATIONAL MAGNETICS CONFERENCE-2000 IEEE INTERMAG;TORONTO, ONT, CAN APR 9-APR 13 2000, 2000, pages GE-03, XP002203140 Dig Intermag Conf;Digests of the Intermag Conference 2000 IEEE, Piscataway, NJ, USA cité dans la demande

## Description

### Domaine technique

L'invention se situe dans le domaine des structures pour capteurs et des capteurs incorporant de telles structures, destinés à la mesure de champs magnétiques créés par exemple par des courants électriques, des aimants, tout matériau ou objet magnétique ou le champ magnétique terrestre ou tout autre champ magnétique.

### Art antérieur.

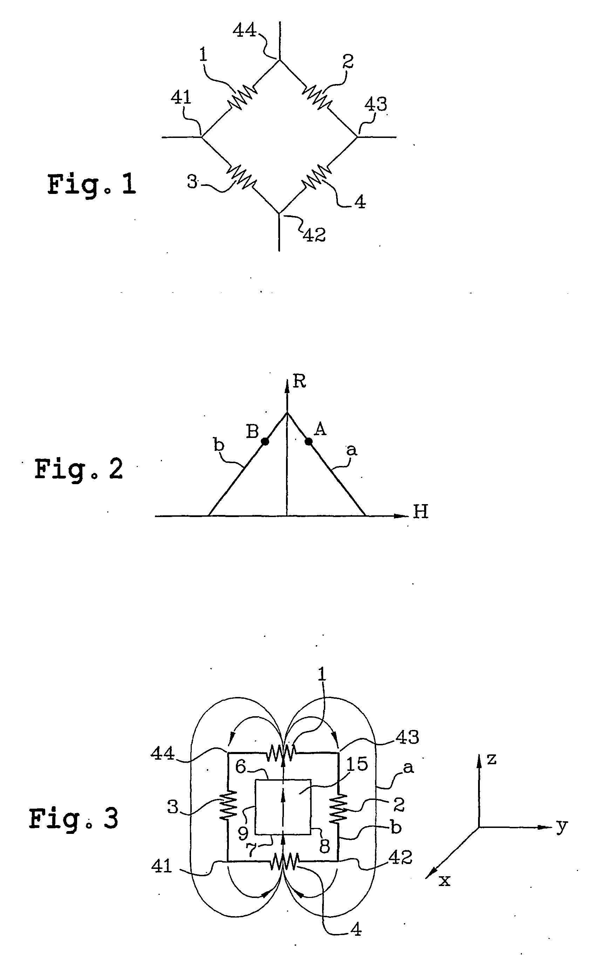

L'article référencé [1] dans une annexe à la présente description décrit une manière de polariser 4 magnétorésistances géantes (GMR) d'un pont de Wheatstone de façon opposée deux à deux en utilisant les champs de fuite d'aimants intégrés. De façon connue et non rappelée dans l'article, le pont de Wheatstone comporte 4 GMR connectées en série en boucle. Il y a ainsi quatre points de connexion entre deux GMR consécutives de la série. Deux paires de points de connexion non consécutifs définissent deux diagonales du pont, une première et une seconde. Une tension est appliquée selon la première diagonale. Lorsque le pont est en équilibre une tension mesurée selon la seconde diagonale est nulle. Lorsque le pont est en déséquilibre, parce que par exemple les valeurs des GMR du pont ont changé sous l'influence de la variation de la valeur d'un champ magnétique, une tension apparaît dans la seconde diagonale dont la valeur est représentative de la valeur du champ magnétique. On notera qu'il est aussi possible d'utiliser un pont diviseur de tension, constitué par deux GMR connectées en série. Les deux GMR ont deux extrémités. Les premières extrémités de chacune des GMR sont connectées entre elles en un point de connexion. Les secondes extrémités de chaque GMR sont connectées à une source de tension de référence. Les variations de valeur de tension aux bornes de l'une des deux GMR sont représentatives des variations du champ magnétique dans lequel sont placées les deux GMR. Pour la polarisation des GMR il est utilisé comme décrit dans l'article, deux aimants, un pour chaque branche du pont. Dans la figure 2 b de cet article représentant une section du capteur en pont, on voit comment les champs de fuite viennent polariser d'une part l'une des GMR dans un sens, d'autre part l'autre GMR dans le sens opposé.

Les quatre GMR, deux pour la direction X et deux pour la direction Y sont réalisées dans un même plan. Il est indiqué dans la première colonne de la page 2783 de cet article que pour chaque branche du pont, l'une des GMR est placée sous le film de CoPt constituant l'aimant permanent à 0,1 µm au dessous. L'autre GMR est placée à 1 µm du flanc du film de CoPt. Il est indiqué également que dans ces conditions les deux magnétorésistances constituant une branche du pont sont soumises à des champs de fuite opposés et d'amplitude à peu près égale. La réponse sous champ du matériau magnétorésistif "pleine tranche", c'est à dire déposé par exemple sur toute la surface d'une tranche de silicium, des GMR est donnée sur la figure 3 de l'article. Il est insisté sur le fait qu'il s'agit de la réponse du matériau et non de la réponse d'une GMR sous forme d'un barreau du matériau. On remarque que la réponse, c'est à dire la valeur de la magnétorésistance en fonction du champ magnétique est linéaire jusqu'au champs magnétique de saturation. Il sera vu plus loin que cette réponse peut être différente dans le cas de motifs gravés sous forme de barreaux. Dans la description de l'article, il est indiqué que chacune des magnétorésistances se présente sous forme d'un barreau de 154 µm de long et de 3 µm de large. Le matériau a un champ de saturation élevé, de l'ordre de 600 oersteds ce qui permet de mesurer des champs allant jusqu'à 150 oersteds avec la polarisation choisie dans cet article. L'aimant a une épaisseur de 0,2 µm. Il est déposé par pulvérisation cathodique (bas de la première colonne de la page 2783 de cet article). On sait que par cette méthode on ne peut déposer des épaisseurs supérieures à 1 µm à cause des contraintes apparaissant dans le matériau. L'aimantation est orientée parallèlement au plan de la couche.

La configuration de capteur à magnétorésistance décrite dans cet article présente plusieurs inconvénients.

Le premier inconvénient est que les magnétorésistances géantes travaillent dans le sens transverse, (haut de la première colonne de la page 2783 de cet article), c'est à dire que les champs magnétiques de polarisation et le champ magnétique à mesurer sont orientés perpendiculairement à la largeur des barreaux GMR. L'Homme du métier sait que dans ces conditions, pour des largeurs telles que celles utilisées dans le dispositif décrit dans l'article, la réponse sous champ du barreau n'est pas linéaire dans la gamme de champs magnétiques comprise entre 0 et une valeur qui dépend du matériau de la magnéto résistance et de sa largeur, ceci à cause d'un effet de forme. Il y a un effet plateau de la courbe représentant la valeur de résistance de la magnétorésistance géante qui est d'autant plus important que la largeur du barreau est faible. Ainsi la demanderesse a effectué des mesures qui montrent que pour un barreau de 64 µm de long et de 1 ou 2 µm de large, la valeur de la magnétorésistance géante ne change pratiquement pas lorsque le champ est compris entre 0 et plus de 200 oersteds. La valeur du plateau pour la même longueur de magnétorésistance est d'environ 170 oersteds pour une largeur de 4 µm, d'environ 80 oersteds pour une largeur de 8 µm et d'environ 40 oersteds pour une largeur de 16 µm. Ainsi il est exclu d'utiliser un capteur tel que celui décrit dans l'article pour la mesure de champs faibles, puisque pour les valeurs faibles on ne note pas de changements significatifs de la valeur de la magnétorésistance géante.

### Brève description de l'invention

Un second inconvénient de l'art antérieur décrit ci-dessus, provient du fait que dans la configuration décrite dans l'article le positionnement des GMR par rapport aux bords des aimants est très critique, et influe directement sur les performances du dispositif. Des simulations effectuées par la demanderesse montrent qu'avec la configuration décrite dans l'article, aimant de faible épaisseur (0,2 µm) et GMR positionnées à 1 µm du bord des aimants, on a un fort gradient du champ magnétique de polarisation d'un bord à l'autre de la GMR. Ainsi on a un champ de polarisation de 270 oersteds sur un premier bord et de 65 oersteds seulement sur l'autre bord distant de 3 µm du premier bord. La polarisation moyenne est de 170 oersteds, proche de celle donnée dans l'article (150 oersteds)

Cette décroissance rapide du champ sur quelques microns signifie qu'un écart de positionnement par exemple de 1 µm vers l'extérieur, de la résistance GMR1 par rapport au bord de l'aimant, va faire passer d'après la simulation, la valeur moyenne de la polarisation de 170 à 95 oersteds. Cette diminution est un inconvénient majeur dans le fonctionnement des GMR, car cela réduit la gamme d'utilisation en champ par rapport à la gamme que l'on croyait pouvoir mesurer. Il se trouve de plus que 1 µm est justement l'ordre de grandeur de l'erreur de positionnement que l'on obtient avec des machines standard de photolithographie utilisées en micro électronique. Il convient de noter également que cette même erreur de positionnement dégrade la reproductibilité plaque à plaque des plaques d'un même lot.

Par rapport à l'état de la technique qui a été décrit, il est proposé selon l'invention un capteur ayant une structure, en accord avec la revendication 1, qui permet de mesurer des champs faibles, par exemple inférieurs à 50 oersteds, qui présente une meilleure reproductibilité quant aux performances des capteurs.

La structure du capteur selon l'invention comporte comme dans l'art antérieur décrit dans l'article précité, un pont de GMR polarisées par des aimants intégrés. Par contre et conformément à l'invention les GMR au nombre de 2 pour former un pont diviseur ou de 4 pour former un pont de Wheatstone ne travaillent pas selon le sens transverse mais selon le sens de plus grande sensibilité qui est généralement le sens longitudinal. Dans la configuration de l'invention, les champs magnétiques de polarisation et le champ magnétique à mesurer sont orientés parallèlement à la longueur des barreaux. Dans cette configuration l'effet de plateau n'est plus présent. La courbe de réponse donnant la valeur de la magnétorésistance en fonction du champ magnétique appliqué est parfaitement linéaire depuis la valeur 0, jusqu'à la valeur du champ de saturation du matériau constituant la magnétorésistance géante. La structure proposée est donc tout à fait adaptée à la mesure de gammes de valeurs incorporant des champs faibles, en particulier des champs inférieurs à 50 oersteds.

Ainsi l'invention est relative à une structure d'un capteur de champ magnétique formée par des aimants et par un pont de magnétorésistances, déposés sous forme de couches sur un même substrat, les magnétorésistances ayant chacune une direction de longitudinale, le pont comportant deux magnétorésistances ou une paire de magnétorésistances, une première et une seconde magnétorésistances ou une première et une seconde paires de magnétorésistances, chaque magnétorésistance étant polarisée par un ou plusieurs aimants ayant chacun deux zones de champ principal d'aimantation, une zone de champ entrant et une zone de champ sortant, alignées selon une direction axiale d'aimantation, et deux zones de champ magnétique de fuite dans lesquelles la direction du champ magnétique est parallèle et de sens opposé à la direction du champ dans les zones de champ principal, la première des deux magnétorésistances du pont ou chacune des magnétorésistances de la première paire de magnétorésistances du pont étant disposées dans une zone de champ principal d'aimants et l'autre magnétorésistance ou chacune des magnétorésistances de la deuxième paire de magnétorésistances du pont étant disposée dans une zone de champ de fuite d'aimants en sorte que les deux magnétorésistances ou les magnétorésistances de chaque paire sont polarisées par des champs magnétiques de directions opposées, caractérisée en ce que le ou les aimants de polarisation sont au même niveau que les magnétorésistances, en ce que tous les aimants de polarisation ont une même direction principale d'aimantation contenue dans le plan des couches et en ce que les magnétorésistances du pont ont leur direction longitudinale parallèle à la direction axiale d'aimantation des aimants.

Lorsqu'il est dit que les magnétorésistances sont au même niveau cela n'exclut pas une légère différence de niveau due par exemple à la présence d'une couche d'isolement présente sous une magnétorésistance et absente sous l'aimant ou l'inverse. Cela exclut qu'une magnétorésistance se trouve sous un aimant comme dans l'art antérieur décrit plus haut.

### Brève description des dessins.

Des exemples de réalisation de l'invention, des résultats et des comparaisons avec l'art antérieur seront expliqués et commentés ci-après en liaison avec les dessins annexés dans lesquels:
La figure 1 représente schématiquement un pont de magnétorésistances.
La figure 2 est une courbe qui représente la variation de la valeur d'une magnétorésistance géante en fonction de la valeur de champs magnétiques dans lesquels elle est placée.
La figure 3 représente schématiquement un premier exemple de réalisation de l'invention dans lequel les magnétorésistances géantes constituant un pont sont disposées sur un même plan qu'un aimant central et autour de celui-ci.
La figure 4 représente schématiquement un deuxième exemple de réalisation de l'invention dans lequel les magnétorésistances géantes constituant un pont sont disposées sur un même plan qu'un aimant central et autour de celui-ci et dans lequel deux des magnétorésistances sont disposées de façon à être en outre dans le champ de deux aimants supplémentaires
La figure 5 représente schématiquement un troisième exemple de réalisation de l'invention dans lequel la polarisation des quatre magnétorésistances géantes constituant un pont est assurée par un aimant central et quatre aimants supplémentaires et dans lequel chaque magnétorésistance est disposée de façon à être dans un champ de l'aimant central et dans le champ d'un aimant supplémentaire.
La figure 6 représente schématiquement un exemple de réalisation technologique des couches constituant la structure d'un capteur de champ magnétique selon l'invention.
La figure 7 représente schématiquement un quatrième exemple de réalisation de l'invention dans lequel la polarisation de quatre magnétorésistances géantes constituant un pont est assurée par un aimant central et quatre aimants supplémentaires rectangulaires ou carrés et dans lequel chaque magnétorésistance est disposée de façon à être dans un champ de l'aimant central et dans le champ d'un aimant supplémentaire.
La figure 8 représente schématiquement, un cinquième exemple de réalisation de l'invention dans lequel chaque magnétorésistance se présente sous la forme d'une série de groupe de doigts de forme longitudinale, chaque groupe étant polarisé par un aimant ou une paire d'aimants qui lui est propre.
La figure 9 représente un autre exemple de réalisation semblable à celui représenté figure 8 dans lequel des séries de doigts constituant des magnétorésistances sont physiquement repliées sur elles-mêmes.
La figure 10 est un ensemble de courbes a-f qui représentent chacune la variation d'une magnétorésistance en fonction du champ magnétique dans lequel elle se trouve. Les courbes a-e sont relatives à l'art antérieur et la courbe f à une magnétorésistance placée selon l'invention.

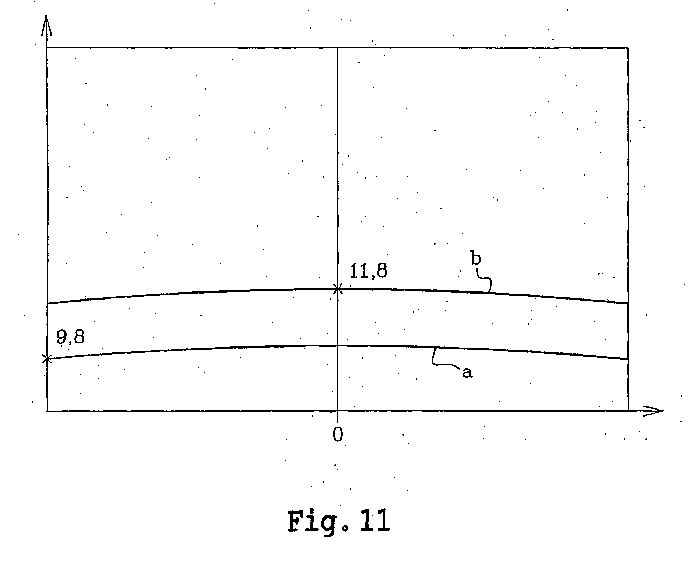

La figure 11 est un ensemble de deux courbes qui représentent les valeurs minimum et maximum du champ magnétique à une même distance de la face d'un aimant et en fonction de la distance dans une direction perpendiculaire au champ pour un dispositif selon l'invention.

### Description détaillée d'exemples de réalisation.

Dans les dessins les éléments ayant même fonction sont représentés par des numéros de référence identiques. Le mot rectangulaire qui sera employé souvent pour caractériser la forme des aimants ou des magnétorésistances doit être pris dans son sens le plus général qui inclut la forme carrée.

On rappellera tout d'abord en référence à la figure 1, le fonctionnement d'un pont diviseur et le fonctionnement d'un pont de Wheatstone.

Un pont diviseur est formé comme indiqué plus haut par deux magnétorésistances par exemple les magnétorésistances 1 et 3 connectées en série entre un point 44 et un point 42. Une tension de référence est appliquée entre les points 42, 44. Les magnétorésistances 1 et 3 sont polarisées par des champs magnétiques de sens opposé. Une tension de sortie mesurée aux bornes de l'une des deux magnétorésistances 1, 3 est représentative de la variation de la valeur des magnétorésistances. Cette valeur des magnétorésistances est elle même une fonction de la valeur du champ magnétique dans lequel la structure formée par les deux magnétorésistances 1 et 3 est plongée. La tension de sortie est ainsi représentative de la valeur dudit champ magnétique.

Le pont de Wheatstone est formé par une série bouclée de quatre résistances. Dans le cas ici envisagé chaque résistance est une magnétorésistance géante 1, 2, 3 et 4. Lorsque le pont n'est pas polarisé les magnétorésistances sont égales entre elles. Les magnétorésistances 1 et 3 forment ensemble une première branche du pont. Les magnétorésistances 2 et 4 forment ensemble une seconde branche du pont.

Pour que le pont de Wheatstone puisse fonctionner il faut qu'au moins une des magnétorésistances soit polarisée. Le fonctionnement le plus performant d'un pont est obtenu lorsque les quatre magnétorésistances du pont sont polarisées deux à deux de façon égale et opposée. Ainsi les magnétorésistances 1 et 4 sont polarisées dans un premier sens par une même valeur et les magnétorésistances 2 et 3 sont polarisées par la même valeur mais en sens opposé.

La figure 2 représente des courbes a et b donnant en ordonnée la valeur d'une magnétorésistance en fonction du champ magnétique qui lui est appliqué. La courbe a représente la valeur des magnétorésistances 1 et 4, auxquelles on applique un champ positif. La courbe b représente la valeur des magnétorésistances 2 et 3 auxquelles on applique un champ négatif. Ainsi on voit qu'appliquer une polarisation de même amplitude mais de signe opposé aux résistances 1, 4 et 2, 3 respectivement revient à déplacer le point de fonctionnement correspondant à un champ nul, vers un point des courbes a et b, par exemple comme représenté figure 2, vers les points A et B.

La polarisation de chacune des magnétorésistances doit être faite de telle sorte que le pont de Wheatstone reste équilibré au repos, c'est à dire lorsque le champ à détecter est nul.

Selon un premier mode de réalisation de l'invention représenté figure 3, un aimant central de polarisation 15 est placé à l'intérieur d'un quadrilatère plan formé par les quatre magnétorésistances 1-4 d'un pont de Wheatstone. Lorsque la structure forme un pont diviseur, la structure ne comporte que deux magnétorésistances par exemple les magnétorésistances 1 et 3. Dans la présente description on s'intéressera essentiellement au cas du pont de Wheatstone. Cependant tout ce qui sera dit par la suite sur les magnétorésistances 1 et 3 est applicable au cas où le pont est un pont diviseur ne comportant que les deux magnétorésistances 1 et 3.

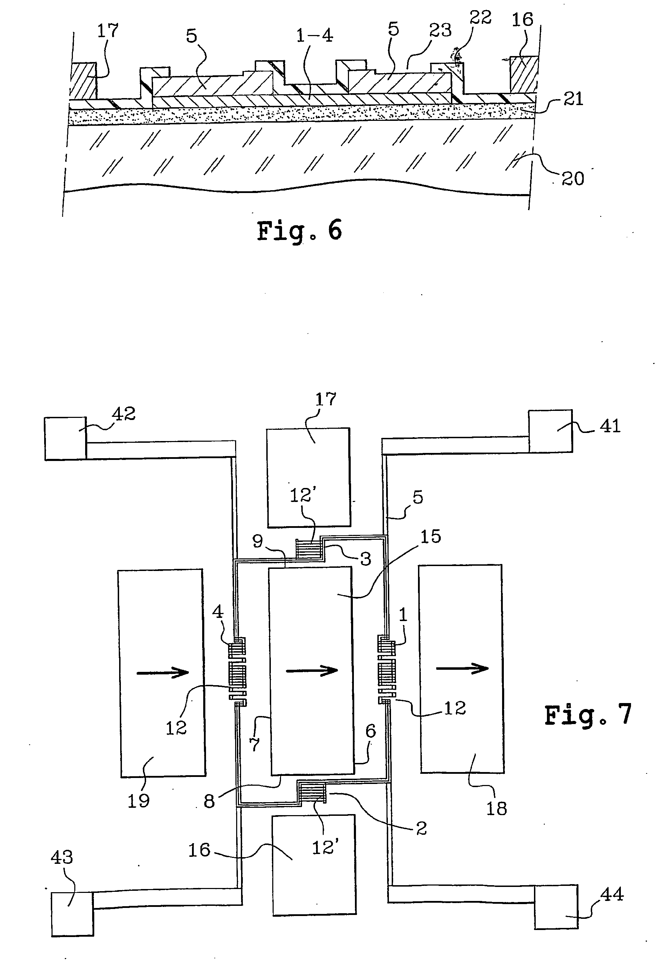

Les aimants et les magnétorésistances sont au même niveau. Lorsqu'on dit au même niveau cela veut dire que les distances des dépôts formant les magnétorésistances et des dépôts formant l'aimant, à un substrat commun sont sensiblement égales. Il sera vu plus loin en liaison avec la description de la figure 6 que les GMR et l'aimant ont une différence de niveau qui ne diffère que par l'épaisseur d'une couche isolante électriquement.

La valeur de la polarisation est choisie en fonction de la valeur du champ que l'on a à détecter. Des valeurs de polarisation différentes sont obtenues avec par exemple des dimensions d'aimants différentes. Dans l'exemple représenté figure 3, l'aimant 15 a selon une section par un plan parallèle au plan des couches une forme rectangulaire, plus spécifiquement carrée. Cette forme n'est nullement obligatoire. L'aimant pourrait avoir par exemple une forme quelconque, par exemple ovale ou rectangulaire à coins chanfreinés ou arrondis. Les magnétorésistances 1 et 4, formant une première paire de magnétorésistances sont placées de part et d'autre de l'aimant 15, la magnétorésistance 1 est dans la zone de champ principal sortant et la magnétorésistance 4 est dans la zone de champ principal entrant. Dans l'exemple ici représenté où l'aimant 15 est rectangulaire ces zones se trouvent face à des faces 6, et 7 respectivement de l'aimant 15. Le champ magnétique principal créé par l'aimant 15 est orienté le long d'une ligne axiale non représentée de cet aimant, de la face 7 à la face 6 perpendiculairement à ces faces. Les magnétorésistances 2 et 3, formant une seconde paire de magnétorésistances, placées respectivement dans les zones de champ de fuite de l'aimant 15 sont dans cette configuration le long des faces 8, 9 perpendiculaires aux faces 6, 7. Les faces 6 et 7 traversées par le flux principal du champ créé par l'aimant 15 seront appelées face de flux principal et les faces 8 et 9 parallèles au champ de fuite seront appelées face de fuite. Sur la figure 3 les lignes de champ et les champs ont été représentés par des lignes a, b et par des flèches. Le champ de fuite est forcément plus faible que le champ principal de l'aimant 15. On recherche donc pour la magnétorésistance 2 ou 3 une distance au bord de l'aimant et une longueur de magnétorésistance permettant d'obtenir la polarisation choisie et la meilleure homogénéité du champ dans la magnétorésistance. Le champ est homogène dans une zone si la valeur du champ est sensiblement constante en chaque point de la zone. On cherche ensuite pour la magnétorésistance 1 ou 4 la distance à la face de l'aimant pour laquelle cette magnétorésistance est polarisée par un champ de même amplitude que celui des magnétorésistances 2 ou 3. Compte tenu de ce qui vient d'être expliqué sur la force des champs principal et de fuite, il en résulte que les magnétorésistances 1 et 4 sont plus éloignées dans cette configuration du bord de l'aimant que les magnétorésistances 2 et 3. Il est souligné à ce stade que sur la figure 3 l'aimant 15 est représenté physiquement selon une section parallèle au plan des couches. Par contre les magnétorésistances 1 et 4 sont représentés simplement pour faire apparaître leurs connexions électriques. Il faut comprendre cependant que compte tenu de la disposition retenue, le vecteur champ traversant chacune des quatre magnétorésistances est parallèle à un axe longitudinal des magnétorésistances 1-4 lui-même parallèle à la direction axiale du champ de l'aimant central 15. Exprimé autrement, il en résulte que les magnétorésistances 1-4 travaillent dans leur direction longitudinale et non plus transversal comme dans l'art antérieur. Afin de repérer les différentes directions, on a représenté figure 3 un trièdre orthonormé dans lequel la direction Oz est la direction du champ magnétique principal de l'aimant 15, la direction Oy est la direction de l'axe perpendiculaire à Oz dans le plan de couche de l'aimant 15. Cette orientation sera conservée dans les modes de réalisation qui seront présentés ultérieurement.

Pour un bon fonctionnement de la structure il est préférable que la géométrie des magnétorésistances soit telle que chaque magnétorésistance soit placée en entier dans une zone où le champ est homogène. Pour les zones de champ principal, situées de part et d'autre de l'aimant 15, cette condition est mieux remplie lorsque la magnétorésistance a son centre géométrique centré sur un axe central de la face de l'aimant dont la magnétorésistance est proche. Dans l'exemple ici commenté les aimants ont des formes rectangulaires les faces 6, 7 de flux principal étant perpendiculaires aux faces 8, 9 de fuite, deux magnétorésistances 1, 4 du pont polarisées par des champs principaux ont leur centre géométrique sensiblement sur un axe central des faces 6, 7 de flux principal, deux autres magnétorésistances 2, 3 du pont polarisées par des champs de fuite ont leur centre géométrique sensiblement sur un axe central des faces 8, 9 de fuite.

Pour satisfaire à la condition de polarisation des magnétorésistances selon une direction longitudinale, les magnétorésistances sont réalisées chaque fois que cela s'avère nécessaire pour rester dans une zone homogène de champ, sous la forme d'une série de magnétorésistances constituées chacune de un ou plusieurs doigts référencés 12 pour les magnétorésistances 1, 4 polarisées par des champs principaux d'aimants et 12' pour les magnétorésistances 2, 3 polarisées par des champs de fuite d'aimants. Ces doigts sont de préférence reliés électriquement l'un à l'autre par le même matériau que celui composant les doigts disposés entre deux extrémités de doigts consécutifs pour former un serpentin. La dimension longitudinale des jonctions entre doigts est perpendiculaire à la direction locale du champ magnétique des aimants. Les doigts peuvent aussi être connectés l'un à l'autre par un élément conducteur. La connexion de liaison entre doigts est comme les autres connexions conductrices référencée 5. Avec ce mode de réalisation de magnétorésistances sous forme d'une série de doigts, il devient possible de moduler la position, la forme et le nombre des doigts constituant chaque magnétorésistance pour que chaque doigt soit orienté longitudinalement parallèlement au champ de polarisation et que l'ensemble des doigts constituant une magnétorésistance soit placé dans une zone homogène de valeur de champ magnétique de polarisation. Compte tenu des symétries des champs autour d'un aimant, deux ou 4 magnétorésistances seront en général réalisées sous forme d'une série de doigts. Ainsi bien que la zone surfacique constituée par des doigts connectés en série formant ensemble une magnétorésistance puisse avoir une forme ayant une direction longitudinale perpendiculaire à la direction du champ principal, la magnétorésistance est dite orientée longitudinalement parallèlement au champ de polarisation parce que chaque doigt est orienté ainsi. Naturellement cette modulation de la position, de la forme et du nombre des doigts constituant chaque magnétorésistance ne doit pas altérer l'égalité entre elles des magnétorésistances constituant le pont de Wheatstone. Ainsi le pont reste équilibré. Des exemples de magnétorésistances constituées de un ou plusieurs doigts disposés afin d'être dans une zone homogène de champ seront donnés plus loin.

Afin d'agrandir la zone homogène de champ il est prévu selon des variantes de réalisation de l'invention d'encadrer les magnétorésistances polarisées par le champ axial ou les magnétorésistances polarisées par le champ de fuite par des aimants.

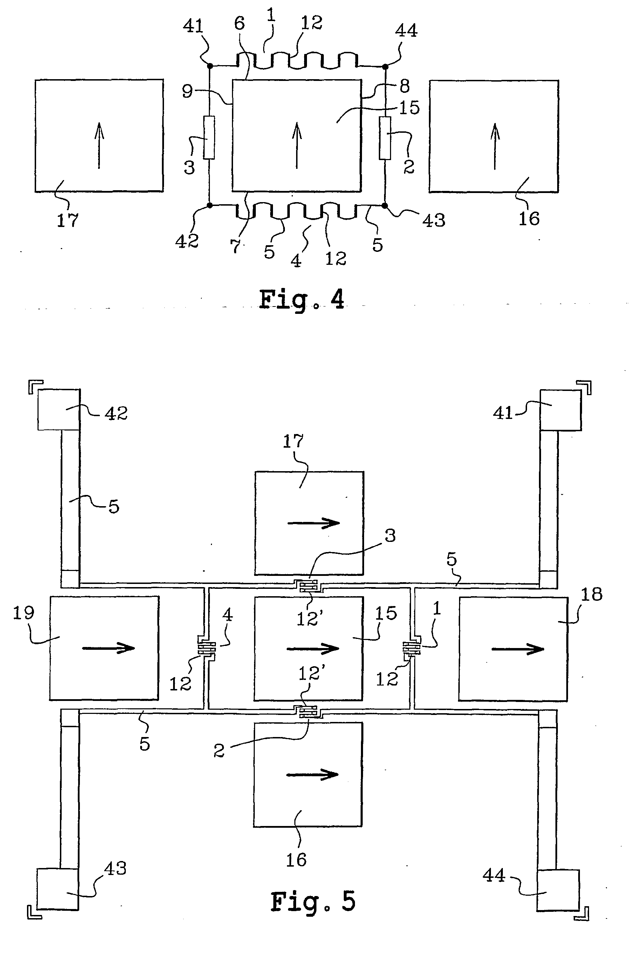

Ainsi selon un deuxième exemple de réalisation de l'invention, représenté figure 4, dans lequel comme dans le cas commenté en liaison avec la figure 3, les quatre magnétorésistances 1-4 forment un quadrilatère plan, des aimants supplémentaires 16, 17 sont disposés de part et d'autre des magnétorésistances 2 et 3 respectivement. Ainsi la magnétorésistance 2 appartenant à la seconde paire de magnétorésistances est encadrée entre l'aimant central 15 situé dans le quadrilatère formé par les quatre magnétorésistances 1-4 et l'aimant 16. De même la magnétorésistance 3 appartenant également à la seconde paire de magnétorésistances est encadrée entre l'aimant central 15 et l'aimant 17. Naturellement il est possible d'envisager une configuration dans laquelle ce sont les magnétorésistances de la première paire qui sont chacune encadrée par des aimants. Ainsi dans ce mode de réalisation la polarisation des deux magnétorésistances polarisées par des champs principaux ou de deux magnétorésistances polarisées par des champs de fuite est assurée en outre par deux aimants supplémentaires l'un étant disposé par rapport à l'aimant central 15 de l'autre côté d'une magnétorésistance à l'extérieur du quadrilatère et l'autre étant disposée par rapport à l'aimant central 15 de l'autre côté d'une autre magnétorésistance à l'extérieur du quadrilatère. Dans l'exemple illustré en liaison avec la figure 4, les aimants supplémentaires 16, 17 sont situés de part et d'autre des magnétorésistances 2 et 3 polarisées par les champs de fuite. On dispose les aimants supplémentaires 16 et 17 de sorte que le champ principal de ces aimants soit parallèle au champ de l'aimant central 15 et à ce que les faces de fuite de ces aimants soient sensiblement centrées sur un axe central des faces de fuite de l'aimant central 15. Dans ces conditions le champ de fuite créé par exemple par l'aimant 16 vient s'additionner au champ de fuite créé par l'aimant 15 au niveau de la magnétorésistance 2 qui est placée entre ces deux aimants. L'effet des aimants supplémentaires 16 et 17 s'analyse ainsi en un renforcement de l'amplitude du champ de polarisation de la GMR, et en un agrandissement de la zone d'homogénéité du champ. Il en est de même de façon symétrique pour la magnétorésistance 3 et l'aimant supplémentaire 17. Dans l'exemple représenté où la zone homogène dans la direction Oz au voisinage des faces 6 et 7 est relativement courte, les magnétorésistances 1 et 4 se présentent sous la forme de plusieurs doigts longitudinaux 12 connectés en série de préférence par des éléments réalisés dans le même matériau que celui constituant les magnétorésistances, ou par des éléments conducteurs 5. Chacun des doigts 12 a son axe longitudinal parallèle au champ principal des aimants 15-17. Les doigts sont placés parallèlement entre eux de façon à ce que l'ensemble des doigts occupe une zone homogène de champ. Dans la pratique afin de simplifier la fabrication, les doigts d'une magnétorésistance sont identiques entre eux, régulièrement espacés et occupent une zone rectangulaire. Cette disposition n'est nullement obligatoire et par exemple les doigts pourraient occuper une zone comprise entre deux courbes, et les doigts centraux ayant par exemple des dimensions longitudinales plus grandes que celles des doigts les plus latéraux, de façon à mieux se conformer à la zone homogène du champ. Les magnétorésistances 2 et 3 situées dans des zones parallèles aux faces 8 et 9 respectivement où le champ est homogène sur une zone étendue dans la direction Oz et étroite dans la direction Oy, se présentent sous forme d'un seul doigt longitudinal dont l'axe longitudinal est lui aussi parallèle au champ principal des aimants 15-17.

Dans le mode préféré de réalisation, représenté en vue de dessus figure 5 chacune des magnétorésistances 1-4 constituant le pont est encadrée entre deux aimants. Ainsi comme dans le cas décrit en liaison avec la figure 4, un premier aimant supplémentaire 16 est disposé de l'autre côté de la magnétorésistance 2 par rapport à l'aimant central 15. Un deuxième aimant supplémentaire 17 est disposé de l'autre côté de la magnétorésistance 3 par rapport à l'aimant central 15. De plus un troisième aimant supplémentaire 18 est disposé de l'autre côté de la magnétorésistance 1 par rapport à l'aimant central 15 et un quatrième aimant supplémentaire 19 est disposé de l'autre côté de la magnétorésistance 4 par rapport à l'aimant central 15. Les aimants 16-19 sont tous situés au même niveau que les magnétorésistances 1-4 et ont leurs aimantations principales parallèles entre elles. Comme dans le cas précédent les aimants supplémentaires augmentent la valeur du champ présent au niveau de chaque magnétorésistance et agrandissent les zones d'homogénéité du champ aux endroits où l'on place les magnétorésistances. On réduit ainsi encore davantage la contrainte de précision de placement des magnétorésistances par rapport aux faces des aimants. Les zones d'homogénéité sont dans ce cas suffisamment agrandies pour qu'il devienne possible que les magnétorésistances 1-4 soient construites de façon identique comme représenté figure 5, avec notamment, le même nombre de doigts. Naturellement selon les valeurs de champ de polarisation et selon la forme des aimants le nombre et la forme des doigts pourront être différents entre les magnétorésistances 1, 4 polarisées par les champs principaux des aimants 15, 18, 19 et les magnétorésistances 2, 3 polarisées par les champs de fuite des aimants 15-17.

Sur la figure 5 les lignes conductrices 5 joignent entre elles outre les doigts consécutifs d'une magnétorésistance, les magnétorésistances 1-4 pour former le pont.

En résumé dans ce mode de réalisation la polarisation des magnétorésistances est assurée par l'aimant central 15 et par quatre aimants supplémentaires disposés à l'extérieur du quadrilatère deux des aimants 18, 19 supplémentaires disposés de part et d'autre de l'aimant central 15, ayant leurs polarisations principales situées sur la ligne axiale de l'aimant central 15 et les deux autres aimants 16, 17 supplémentaires disposés de part et d'autre de l'aimant central 15 ayant leurs polarisations principales situées sur des lignes axiales parallèles à celle de l'aimant central 15, distinctes entre elles et distinctes de la ligne axiale de l'aimant central 15.

Un exemple d'empilement de couches pour réaliser les magnétorésistances, les aimants et les isolements et contacts sera maintenant décrit en liaison avec la figure 6. Cette figure représente une section transversale d'une partie de la structure en pont. Sur un substrat en silicium 20 est tout d'abord déposée une couche isolante 21 par exemple en silice. On dépose alors sur toute la surface du substrat le matériau constituant les magnétorésistances 1-4. Il pourra s'agir par exemple de FeNiAg multicouche déposé par pulvérisation cathodique. Le multicouche ainsi déposé est ensuite gravé en tant que de besoin pour former les différents doigts orientés comme indiqué plus haut. Après masquage des parties ne devant pas porter de lignes conductrices, on dépose les lignes conductrices 5 et les plots de contact. Les lignes conductrices 5. relient entre eux les différents doigts afin de les mettre en série, ferment le pont formé par les 4 magnétorésistances. Les dépôts conducteurs sont réalisés par exemple en Au ou Cu ou autre métal ou alliage conducteur, déposé par exemple par pulvérisation cathodique, ou par évaporation sous vide ou encore par dépôt électrolytique ou par tout autre moyen. On dépose ensuite des couches isolantes 22, par exemple en SiO₂ ou Si₃N₄ ou en résine ou autre isolant, destinées à bien séparer galvaniquement les aimants et les magnétorésistances munies de leurs lignes conductrices 5 et de leurs contacts. Les aimants 16-19 sont alors déposés, par exemple par voie électrochimique. Il peut s'agir d'un alliage ferromagnétique ou d'un empilement multicouche de matériaux ferromagnétiques tels que Co, Fe et d'autres matériaux métalliques non ferromagnétiques tels que Pt, Cu, Ag ou Pd. Les exemples de matériau ne sont pas limitatifs. La couche déposée est ensuite gravée pour délimiter les aimants. On vient ensuite ouvrir la couche d'isolant 21, au niveau d'emplacements 23 de reprise des contacts électriques. Ainsi dans cette configuration les aimants et les magnétorésistances sont à l'épaisseur près de la couche isolante 22 situés au même niveau.

La figure 7 représente un exemple de réalisation comportant comme dans le cas représenté en liaison avec la figure 5 un aimant central 15 disposé au centre d'un quadrilatère formé par les quatre magnétorésistances du pont, et quatre aimants supplémentaires 16-19 disposés chacun de l'autre côté d'une magnétorésistance par rapport à l'aimant central 15. Dans la configuration représentée figure 7, l'aimant central a une forme rectangulaire avec une dimension selon la direction principale d'aimantation plus petite que la dimension transverse. Les aimants 18 et 19 situés respectivement de part et d'autre des résistances 1 et 4, situées dans le champ magnétique principal, ont la même forme rectangulaire que l'aimant central 15. Les magnétorésistances 1 et 4 sont formées d'un même nombre de doigts identiques 12. De même les magnétorésistances 2 et 3 situées dans les champs de fuite des aimants 15, 16 et 15, 17 respectivement ont un même nombre de doigts identiques 12'. Le nombre de doigts des magnétorésistances 2, 3 situées dans les champs de fuite est inférieur au nombre de doigts des magnétorésistances 1, 4 situées dans les flux principaux. En contre partie pour obtenir une égalité des quatre magnétorésistances, les doigts 12' des magnétorésistances 2, 3 situées dans les champ de fuite sont plus longs que les doigts 12 des magnétorésistances 1, 4 situées dans les champs principaux.

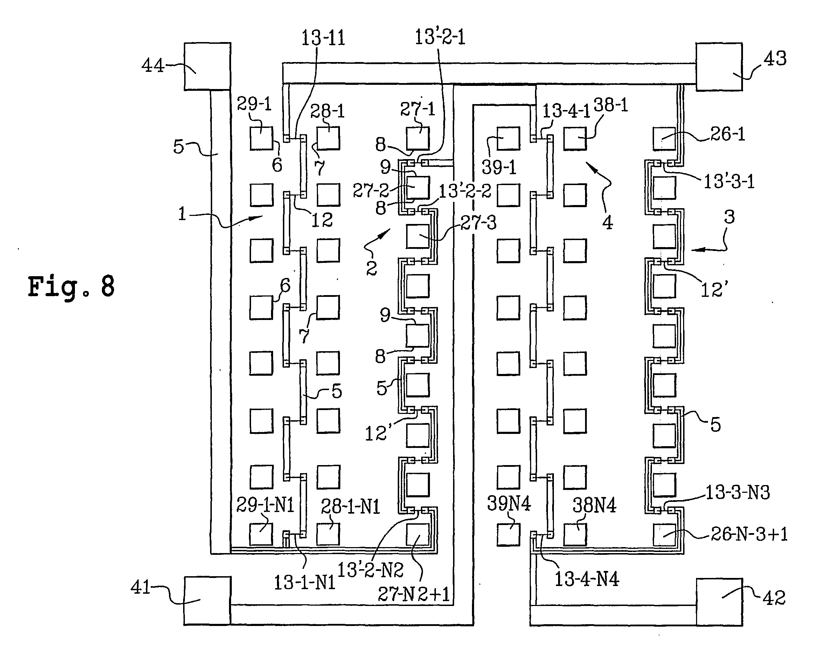

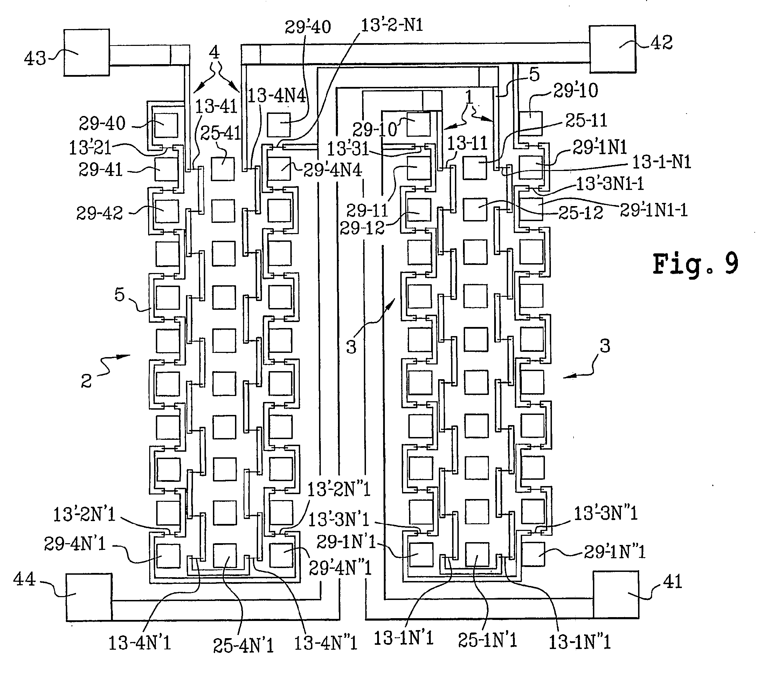

Il a été commenté en liaison avec les figures 3, 4, 5 et 7 des exemples de réalisation dans lesquels les quatre magnétorésistances 1-4 forment un quadrilatère plan et où chaque magnétorésistance est polarisée par un ou deux aimants. Cette configuration n'est nullement obligatoire. Il va être commenté ci-après en liaison avec les figures 8 et 9, des exemples de réalisation dans lequel les quatre magnétorésistances sont disposées sur des lignes axiales parallèles entre elles. Plus précisément chacune des magnétorésistances 1-4 est formée par des doigts 12 ou 12' dont la dimension de plus grande longueur est placée parallèlement à Oz. Ces doigts sont connectés entre eux en série par des conducteurs 5. Les centres géométriques des doigts des magnétorésistances sont alignés selon des directions parallèles à Oy. Les dimensions des magnétorésistances ainsi formées sont nettement plus importantes dans la direction Oy que dans la direction Oz, c'est pourquoi il est dit que les magnétorésistances 1-4 sont sur des lignes axiales parallèles entre elles. La direction Oz est la direction axiale d'aimantation d'un ensemble d'aimants dont il sera parlé plus loin. La première magnétorésistance 1 est formée par un premier ensemble de N1 premiers groupes de doigts 12. Les groupes de doigts sont référencés figures 8 et 9, 13-11 à 13-1N1 pour les groupes de doigts de la première magnétorésistance, 13'-21 à 13'-2N2 pour les groupes de doigts de la deuxième magnétorésistance, et de façon analogue, 13'-31 à 13'-3N3 et 13-41 à 13-4N4 pour les groupes de doigts des troisième et quatrième magnétorésistances. Les doigts de chaque groupe et les groupes sont connectés en série en sorte que chaque résistance comporte un nombre de doigts connectés en série qui est égal au nombre de doigts de chaque groupe multiplié par le nombre de groupes constituant ensemble une magnétorésistance. Les nombres N1, N2, N3, et N4, sont des entiers supérieurs à 1. Sur les figures 8 et 9, dans un but de simplification de la figure chaque groupe ne comporte qu'un doigt. En se référant à la figure 8, chaque groupe de N1 doigts est polarisé par le champ principal de un ou deux aimants. Il y a donc N1 ou 2N1 aimants. Dans la représentation de la figure 8, il a été représenté un cas où il y a 2N1 aimants référencés 29-1 à 29-N1 et 28-1 à 28-N1. Chacun des doigts des N1 groupes de doigts a sa direction longitudinale, perpendiculaire aux faces 6, 7 de flux principal de deux aimants 28, 29 de même rang, formant ensemble une paire de polarisation de champ principal, et chaque groupe a son centre géométrique situé au centre de la zone de champ principal, sur un axe central de ces faces. Ainsi par exemple, le groupe 13-1 de doigts est situé entre la face 6 de l'aimant 29-1 et la face 7 de l'aimant 28-1, et ainsi de suite jusqu'au groupe 13-1N1 de doigts 12 qui a son centre géométrique entre la face 6 de l'aimant 29-N1 et la face 7 de l'aimant 28-N1. Les aimants 29 et 28 sont, dans l'exemple représenté figure 8, tous semblables entre eux. La quatrième magnétorésistance 4 est constituée de la même façon d'un ensemble de N4 quatrièmes groupes de doigts 12 référencés 13-41 à 13-4N4 disposés de la même façon chacun entre une face 6 d'un aimant 39 et une face 7 d'un aimant 38. Ainsi chacun des groupes de doigts 12 composant les magnétorésistances 1 et 4 sont polarisés par le champ principal d'un aimant ou d'une paire d'aimants qui lui est propre, les deux aimants de chaque paire étant situés sur une même ligne axiale parallèle à la direction axiale d'aimantation des deux aimants. La magnétorésistance 2 est composée elle aussi par un ensemble de N2 deuxièmes groupes 13'-21 à 13'-2N2 de doigts 12'. Les doigts 12' de chaque deuxième groupe 13'-2 et les N2 groupes sont connectés en série en sorte que chaque résistance comporte un nombre de doigts connectés en série qui est égal au nombre de doigts 12' de chaque groupe multiplié par le nombre N2 de groupes. Les aimants de polarisation des N2 groupes sont dans cet exemple de réalisation disposés en colonne. Chacun des N2 groupes 13'-2 de doigts est placé entre les faces de fuite 8, 9 de deux aimants consécutifs 27 de la colonne. Ainsi le groupe 13'-21 est placé entre la face de fuite 8 d'un aimant 27-1 et la face de fuite 9 d'un aimant 27-2, le groupe 13'-22 est placé entre la face de fuite 8 de l'aimant 27-2 et la face de fuite 9 d'un aimant 27-3, et ainsi de suite jusqu'au deuxième groupe de doigts 13'-2N2 qui est placé entre la face de fuite 8 d'un aimant 27-N2 et la face de fuite 9 d'un aimant 27-(N2 + 1). Ainsi s'il y a N2 groupes de doigts 12', il y a (N2 + 1) aimants 27. Chacun des N2 deuxièmes groupes de doigts 12' est ainsi polarisé par les champs de fuite de deux aimants 27 consécutifs. Enfin la magnétorésistance 3 est composée et disposée de la même façon que la magnétorésistance 2. On veut dire que la magnétorésistance 3 est formée par un nombre N3 de troisièmes groupes 13' de doigt 12'. Chaque troisième groupe de doigts est polarisé par les champs de fuite de deux aimants 26 consécutifs référencés 26-1 à 26-(N3 +1) d'une colonne d'aimants. Les doigts d'un groupe sont connectés entre eux par des éléments 5 constitués du même matériau que les doigts. Les groupes de doigts et les magnétorésistances 1-4 sont connectés électriquement entre elles par des conducteurs 5 terminés par des plots de contact 41-44 assurant les connexions de jonction de deux magnétorésistances consécutives avec l'extérieur. Il convient de noter que pour des raisons de simplification de conception et de fabrication les nombres N1 et N4 seront en général égaux. Les aimants 29 28, et 39, 38 polarisant les magnétorésistances 1, 4 seront identiques entre eux et identiques à ceux 27, 26 polarisant les magnétorésistances 2, 3. Les doigts 12 seront de préférence identiques entre eux. Dans l'exemple représenté figure 8 les aimants, 28-29 et 38, 39 polarisant respectivement les magnétorésistances 1, 4 sont disposés selon 4 colonnes parallèles. Cette disposition est avantageuse car elle permet un gain de place sur une puce portant la structure, mais il convient de noter qu'elle n'est pas obligatoire. Il suffit que chaque premier et quatrième groupe de doigts soit entre les faces de flux principal de deux aimants, la forme des liaisons 5 étant alors adaptée à l'emplacement retenu pour les doigts 12 des magnétorésistances 1, 4. La disposition en colonne des aimants 26, 27 des aimants polarisant les magnétorésistances 2, 3 n'est pas obligatoire non plus, bien qu'elle permette un gain de place important, chaque aimant à l'exception des aimants terminaux de la colonne polarisant deux groupes de doigts 12'.

En résumé dans le mode de réalisation décrit en liaison avec la figure 8, les doigts composant ensemble la magnétorésistance de la première magnétorésistance 1 sont répartis en un premier ensemble de N1 premiers groupes de doigts, les doigts composant ensemble la quatrième magnétorésistance 4 sont répartis en un quatrième ensemble de N4 quatrièmes groupes de doigts, en ce que les doigts 12' composant ensemble la deuxième magnétorésistance 2 sont répartis en un deuxième ensemble de N2 deuxièmes groupes de doigts 12', et en ce que les doigts composant ensemble la troisième magnétorésistance sont répartis en un troisième ensemble de N3 troisièmes groupes de doigts 12'. Chacun des premiers groupes de doigts est placé dans le champ principal d'un ou d'une paire d'aimants distincts en sorte qu'il y a N1 ou 2N1 aimants de polarisation de la première magnétorésistance, chacun des quatrièmes groupes de doigts est placé dans le champ principal d'un ou d'une paire d'aimants distincts en sorte qu'il y a N4 ou 2N4 aimants de polarisation de la quatrième magnétorésistance 4, chacun des troisièmes groupes de doigts étant placé dans le champ de fuite de deux aimants consécutifs distincts, lesdits aimants consécutifs distincts étant disposés en colonne en sorte qu'il y a (N3 + 1) aimants de polarisation de la troisième magnétorésistance 3, chacun des deuxièmes groupes de doigts est placé dans le champ de fuite de deux aimants consécutifs distincts, lesdits aimants consécutifs distincts étant disposés en colonne en sorte qu'il y a (N2 + 1) aimants de polarisation de la deuxième magnétorésistance.

Un mode de réalisation semblable dans son principe à celui de la figure 8 sera maintenant décrit en liaison avec la figure 9.

Dans ce mode de réalisation les magnétorésistances 1-4 sont comme dans le cas précédent réparties respectivement en N1-N4 groupes de doigts. Les N1 et N 4 groupes de doigts composant ensemble la première et la quatrième magnétorésistances respectivement sont alignés selon au moins deux colonnes parallèles. Sur la figure 9 on a représenté deux colonnes pour chacune des magnétorésistances 4 et 1. La première colonne de doigts de la magnétorésistance 1 représentée sur la partie droite de la figure, comporte les groupes de doigts référencés 13-11 à 13-1N'1, la seconde colonne comporte les groupes de doigts 13-1N"1 à 13-1N1. De même, la première colonne de doigts de la magnétorésistance 4, représentée sur la partie gauche de la figure 9, comporte les groupes de doigts référencés 13-41 à 13-4N'4, la seconde colonne comporte les groupes de doigts 13-4N"4 à 13-4N4. Les nombres N'1 et N"1 sont compris entre 2 et N1 mais [N'1+(N1-N"1+1)] n'est pas nécessairement égal à N1. Il en va de même pour les groupes de doigts composant la magnétorésistance 4. Cela exprime que tous les groupes de doigts composant la magnétorésistance 1 ou la magnétorésistance 4 ne sont pas nécessairement tous compris dans les deux colonnes de doigts relative à chacune des magnétorésistances 1 et 4 respectivement. Dans l'exemple représenté tous les groupes de doigts des magnétorésistances 1 et 4 sont répartis dans les deux colonnes de groupes de doigts de chacune des magnétorésistances. De préférence et comme représenté figure 9, les nombres N1 et N4 sont pairs et chacune des colonnes comporte le même nombre de groupes de doigts. Dans ce cas N'1 = N1/2, N"1 = N1/2+1 =N'1+1 et N'4 = N4/2, N"4 = N4/2+1 = N'4+1. Ainsi des groupes de doigts de chacune des première et quatrième magnétorésistances respectivement sont répartis en paires. Chaque paire comprend un premier membre et un second membre. Le premier membre d'une paire est situé à la fois dans la zone de champ entrant d'un aimant central 25 et dans la zone de champ sortant d'un premier aimant latéral 29. Le second membre de ladite paire est situé à la fois dans la zone de champ sortant dudit aimant central 25 et dans la zone de champ entrant d'un second aimant latéral 29'. Les premier et second aimants latéraux 29, 29' et les aimants centraux 25 forment des colonnes d'aimants parallèles entre elles. Ainsi par exemple une première colonne d'aimants latéraux polarisant la première magnétorésistance 1 comprend les premiers aimants référencés 29-11 à 29 1N'1. La colonne d'aimants centraux 25 comprend les aimants 25-11 à 25-1N'1 et la seconde colonne de seconds aimants latéraux 29' comprend les aimants référencés 29'1N'1+1 à 29'1N1. La première paire de groupes doigts a un premier membre 13-11 situé à la fois dans la zone de champ principal sortant du premier aimant latéral 29-11 de la première colonne d'aimant latéraux et dans la zone de champ principal entrant du premier aimant central 25-11. La première paire de groupes doigts a un second membre 13-1N1 situé à la fois dans la zone de champ principal sortant du premier aimant central 25-11 de la colonne d'aimant centraux et dans la zone de champ principal entrant du dernier second aimant latéral 29'-1N1 de la seconde colonne d'aimants latéraux 29'. De même la seconde paire de groupes doigts a un premier membre situé à la fois dans la zone de champ principal sortant du deuxième premier aimant latéral 29-12 de la première colonne d'aimant latéraux et dans la zone de champ principal entrant du deuxième aimant central 25-12. La deuxième paire de groupes doigts a un second membre situé à la fois dans la zone de champ principal sortant du deuxième aimant central 25-12 de la colonne d'aimants centraux et dans la zone de champ principal entrant du deuxième second aimant latéral 29'-1N1-1 de la seconde colonne d'aimants latéraux de polarisation de la première magnétorésistance. Il en va ainsi jusqu'à la dernière paire de groupes de doigts de la première colonne de groupes de doigts de la première magnétorésistance dont le premier membre 13-1N'1 est situé à la fois dans la zone de champ principal sortant du dernier premier aimant latéral 29-1N'1 de la première colonne d'aimant latéraux 29 et dans la zone de champ principal entrant du dernier aimant central 25-1N'1. La dernière paire de groupes doigts a un second membre 13-1N"1 situé à la fois dans la zone de champ principal sortant du dernier aimant central 25-1N'1 de la colonne d'aimants centraux et dans la zone de champ principal entrant du dernier second aimant latéral 29'-1N"1 de la seconde colonne d'aimants latéraux de polarisation de la première magnétorésistance.

La quatrième magnétorésistance a ses groupes de doigts disposés de la même façon. Le premier membre de chaque paire de groupe est disposé dans la zone de champ principal entre deux aimants, un premier appartenant à une première colonne latérale d'aimants 29-4, et un aimant central 25-4 d'une colonne d'aimants centraux de polarisation de la quatrième magnétorésistance. Le second membre de chaque paire de groupe de doigts est disposé dans la zone de champ principal entre deux aimants, un aimant central 25-4 de la colonne d'aimants centraux 25-4 de polarisation de la quatrième magnétorésistance et un second appartenant à une seconde colonne latérale d'aimants 29'-4.

Si comme représenté figure 9 tous les doigts composant ensemble la première et la quatrième magnétorésistances respectivement sont répartis en paires en sorte que les nombres N1 et N4 sont des entiers pairs, il y a 3N1/2 aimants de polarisation de la première magnétorésistance 1 répartis en trois colonnes parallèles comportant chacune au moins N1/2 aimants, et 3N4/2 aimants de polarisation de la quatrième magnétorésistance 4 répartis en trois colonnes parallèles comportant chacune au moins N4/2 aimants.

La répartition des groupes 13' de doigts 12' composant les magnétorésistances 2 et 3 sera maintenant abordée.

Dans le mode de réalisation représenté figure 9, des groupes 13' de doigts 12' composant ensemble les seconde et troisième magnétorésistances sont situés dans les zones de champ de fuite de deux aimants consécutifs de colonnes d'aimants latéraux.

Plus précisément dans le mode de réalisation représenté figure 9, où les magnétorésistances 1-4 ont le même nombre de groupes de doigts, chaque intervalle entre deux aimants consécutifs 29-4, 29'-4 ou 29-1, 29'-1 des colonnes d'aimants latéraux 29 loge isolément l'un des groupes de doigts constituant les magnétorésistances 2 et 3. Ainsi par exemple N'1-1 groupes de doigts référencés 13'-31 à 13'-3(N'1-1) composant ensemble une partie de la troisième magnétorésistance 3 sont logés chacun de façon isolée dans les (N'1-1) intervalles entre les N'1 premiers aimants formant ensemble la première colonne d'aimants latéraux 29-11 à 29-1N'1 de polarisation de la magnétorésistance 1. De même N"1-1 groupes de doigts référencés 13'-3N"1 à 13'-3(N1-1) composant ensemble une autre partie de la troisième magnétorésistance 3 sont logés isolément chacun dans l'un des intervalles entre les seconds aimants latéraux 29'-1N"1 à 29'-1N1 de la seconde colonne d'aimants latéraux de polarisation de la première magnétorésistance 1.

Il en va de même pour les groupes de doigts composant ensemble la magnétorésistance 2 qui sont logés dans les intervalles entre les aimants latéraux 29-4 et 29'-4 des première et seconde colonnes respectivement d'aimants de polarisation de la magnétorésistance 4.

On voit que compte tenu du nombre d'intervalles entre aimants consécutifs des colonnes d'aimants latéraux il manque un intervalle dans chacune des colonnes pour loger l'un des groupes de doigts de magnétorésistance polarisée par des champs de fuite. Pour créer cet intervalle manquant chaque colonne d'aimants latéraux comporte un aimant supplémentaire. Ces aimants ont été référencés, 29-10 et 29'10 pour les deux colonnes d'aimants latéraux de polarisation de la magnétorésistance 1 et 29-40, 29'-40 pour les deux colonnes d'aimants latéraux de polarisation de la magnétorésistance 4.

D'une façon générale on peut dire pour définir les modes de réalisation tels qu'ils sont représentés sur les figures 8 ou 9, que les aimants de polarisation sont répartis de façon matricielle en lignes et colonnes, en ce que les doigts composant ensemble chaque magnétorésistance sont répartis en groupes de doigts et en ce que des groupes de doigts appartenant à des magnétorésistances polarisées par des champs principaux sont logés dans les zones de champ principal entre aimants de colonnes consécutives appartenant à une même ligne et en ce que des groupes de doigts appartenant à des magnétorésistances polarisées par des champs de fuite sont logés dans des zones de champ de fuite entre aimants consécutifs appartenant à une même colonne.

Si le pont est un pont diviseur il ne comporte que deux magnétorésistances, par exemple les magnétorésistances 1 et 3 représentées figure 9. Dans ce cas il comporte au moins 3 colonnes d'aimants, réparties en une colonne centrale et deux colonnes latérales. Des groupes de doigts logés dans les zones de champ de fuite sont présents uniquement entre aimants consécutifs appartenant aux colonnes latérales. Si le pont est un pont de Wheatstone il y a quatre magnétorésistances et dans ce cas il y a au moins deux paires de 3 colonnes comme représenté figure 9.

Dans le mode de réalisation représenté figure 9 qui est préféré l'aimant de la première ligne de chaque colonne centrale d'aimants 25 est absent. Un groupe de doigts logés dans les zones de champ de fuite entre aimants consécutifs appartenant aux colonnes latérales est présent dans chacun des intervalles entre aimants consécutifs de ces colonnes. Un groupe de doigts appartenant à des magnétorésistances polarisées par des champs principaux est présent entre chacun des intervalles entre aimants consécutifs d'une même ligne à l'exception de la première.

Naturellement il est possible d'utiliser les colonnes d'aimants centraux 25-4 ou 25-1 pour loger des groupes de doigts dans les zones de fuite entre aimants consécutifs de ces colonnes. On note toutefois qu'il convient alors que les conducteurs 5 reliant les groupes de doigts consécutifs formant par exemple les magnétorésistances 1 et 3 doivent se croiser, ce qui impose de déposer un isolant entre couches de conducteurs 5 et donc complique la fabrication. Dans les configurations représentées figures 8 ou 9 on remarque qu'il n'y a pas de croisement entre les conducteurs 5 de magnétorésistances. Ainsi par exemple, dans le mode de réalisation représenté figure 9, la magnétorésistance 1 formée par des groupes 13 de doigts 12 et des conducteurs 5 a une forme générale en U. Il en va de même pour les groupes 13' de doigts 12' et les conducteurs 5 formant ensemble la magnétorésistance 3. Le U de la magnétorésistance 3 est situé entièrement à l'extérieur et autour du U formant la magnétorésistance 1. Il n'y a ainsi aucun croisement entre conducteurs 5 de ces deux magnétorésistances.

Par rapport au mode de réalisation représenté figure 8, le mode de réalisation de la figure 9, en particulier son mode préféré, permet de loger un plus grand nombre de doigts sur une même surface du fait que, à l'exception de la première ligne, tous les intervalles entre aimants consécutifs de la matrice d'aimant sont utilisés. On peut donc obtenir des magnétorésistances de forte valeur, et utiliser des tensions de pont élevées tout en ayant des courants faibles circulant dans les magnétorésistances.

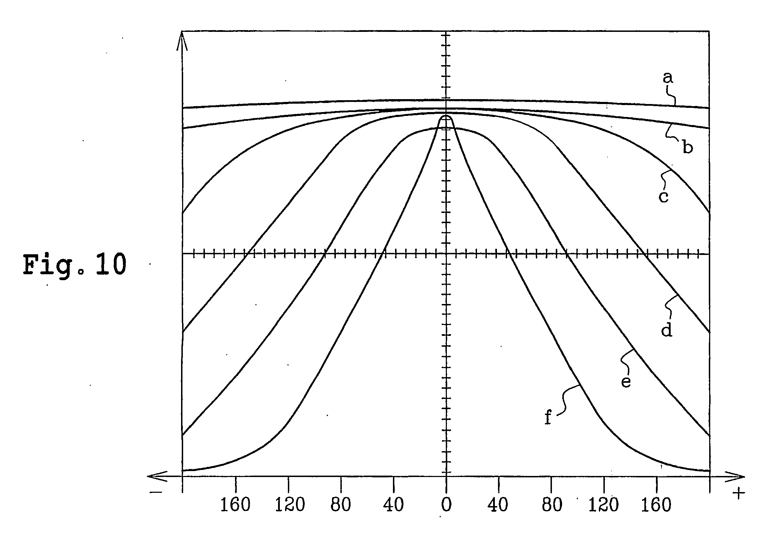

Des comparaisons avec l'art antérieur et des exemples chiffrés de réalisation seront maintenant commentes en liaison avec les figures 9 et 10 qui représentent des courbes.

Lors du commentaire de l'art antérieur effectué plus haut, il avait été expliqué que la courbe de variation d'une magnétorésistance ayant une forme de barreau rectangulaire et polarisée dans le sens de sa largeur présentait un plateau. Les courbes a à e de la figure 9 représentent la variation de la magnétorésistance de barreaux rectangulaires ayant tous 0,05 µm d'épaisseur, 64 µm de longueur, et des largeurs de 1 µm pour la courbe a, 2 µm pour la courbe b, 4 µm pour la courbe c, 8 µm pour la courbe d et 16 µm pour la courbe e. Ces magnétorésistances sont polarisées transversalement. On voit sur ces courbes un effet plateau, au voisinage de 0. La magnétorésistance représentée en ordonnée ne varie pratiquement pas lorsque le champ magnétique représenté en abscisse a une valeur positive ou négative, qui ne dépasse pas un certain seuil. Ce seuil est d'autant plus important que la magnétorésistance a une largeur faible. La courbe f représente la variation de la magnétorésistance pour un barreau de 0,05 µm d'épaisseur, 64 µm de longueur et 4 µm de largeur, donc identique à celui de la courbe c, mais polarisé longitudinalement. On constate que cette courbe présente une variation linéaire avec le champ pratiquement depuis la valeur 0, jusqu'à une valeur de champ d'environ 120 oersteds correspondant à la saturation. On note que pour cette valeur le même barreau polarisé transversalement est encore dans sa partie plateau. Il en résulte qu'une structure selon l'invention incorporée dans un capteur permet de mesurer des champs plus faibles avec des mêmes formes de magnétorésistance.

La figure 10 illustre les variations du champ à l'intérieur de magnétorésistances polarisées par un seul aimant positionné au centre d'un quadrilatère formé par les 4 magnétorésistances formant le pont, comme illustré figure 3. L'aimant central 15 à des dimensions de 500x500 µm² et une épaisseur de 4 µm. Il présente une aimantation rémanente de 5000 gauss. La magnétorésistance 1 est constituée par dix doigts connectés en série. Chaque doigt a une longueur de 20µm et une largeur de 4 µm. L'épaisseur de chaque doigt est de 0,05 µm. L'espacement entre doigts consécutifs est de 10 µm Le centre de chaque doigt est placé à une distance de 200 µm de la face 6 de flux principal de l'aimant. Les doigts forment ainsi ensemble un rectangle dont la plus grande dimension est de 130 µm environ et dont la plus petite dimension est de 20 µm. Le centre géométrique de cette magnétorésistance est le centre géométrique de ce rectangle. Il est situé sur l'axe central de la face 6 à 200 µm de cette face. Les courbes a et b de la figure 10 représentent en ordonnée la valeur du champ de polarisation en oersteds en fonction de la valeur de l'abscisse selon la direction perpendiculaire à la direction d'aimantation principale de l'aimant 15. Les abscisses sont mesurées de - 70 µm à + 70 µm, c'est à dire du premier au dernier doigt de la magnétorésistance 1. La courbe a représente la valeur du champ lorsqu'on est à 210 µm de la face 6 de l'aimant, c'est à dire au niveau du bord de la magnétorésistance 1 le plus éloigné de la face 6 de l'aimant. La courbe b représente la valeur du champ lorsqu'on est à 190 µm de la face 6 de l'aimant, c'est à dire au niveau du bord de la magnétorésistance 1 le plus proche de la face 6 de l'aimant. On voit dans ces conditions que l'écart maximum de valeur de champ dans la magnétorésistance 1 est de deux oersteds, la valeur maximum du champ étant de 11, 8 et la valeur minimum de 9,8 oersteds.

Dans cette même configuration avec un seul aimant les magnétorésistances 2 et 3 polarisées par les champs de fuite sont constituées par un seul doigt de 200 µm de long et 4 µm de large. Ces magnétorésistances sont placées avec leur axe longitudinal parallèle aux faces de fuite 8, 9. Le centre géométrique du doigt est placé à 25 µm de la face. Dans ces conditions la variation maximum du champ dans chaque magnétorésistance est de 1,75 oersteds compris entre une valeur maximum de 12 oersteds et une valeur minimum de 10,25 oersteds.

On décrira maintenant les résultats obtenus avec la configuration de polarisation décrite en liaison avec la figure 4. Les magnétorésistances 2 et 3 sont polarisées chacune avec les champs de fuite de deux aimants, l'aimant central 15 et un aimant supplémentaire 16, 17. Les 3 aimants 15-17 sont identiques à l'aimant unique 15 décrit précédemment. Les magnétorésistances 1 et 4 sont constituées par 10 doigts identiques de 20 x 4 µm, avec un espacement entre doigts de 10 µm Les magnétorésistances 1 et 4 occupent ainsi chacune une surface de 130 x 20 µm. La grande dimension de chaque magnétorésistance s'étend parallèlement aux faces 6 et 7 respectivement. Le centre géométrique de ces magnétorésistances est à une distance de 130 µm des faces 6, 7 respectivement. La simulation montre que le champ moyen est de 19,7 oersteds avec un champ maximum de 22 oersteds et un champ minimum de 17,5 oersteds.

Les magnétorésistances 2 et 3 sont elles constituées par un barreau unique de 200x4 µm ayant son centre géométrique placé à 50 µm respectivement des faces de fuite 8 et 9, les faces de fuite en regard des aimants 15, 16 et 15, 17 étant distantes l'une de l'autre de 100 µm. La simulation montre que le champ moyen est de -19,2 oersteds avec un champ maximum de -20,2 oersteds et un champ minimum de -18,2 oersteds. Grâce aux deux aimants supplémentaires qui encadrent les magnétorésistances 2 et 3 la surfacé de champ homogène est agrandie en sorte qu'il devient possible d'envisager d'avoir des formes identiques pour les 4 magnétorésistances.

Un exemple de configuration avec un aimant central 15 et 4 aimants supplémentaires 16-19 tel que représenté figure 5 sera maintenant commenté. Les 5 aimants sont identiques entre eux et identiques à ce qui a déjà été décrit pour l'aimant unique 15. Les quatre magnétorésistances 1-4 sont identiques entre elles. Chacune est constitué par 5 doigts de 40 µm de long et 4 µm de large. L'espacement entre doigts consécutifs d'une magnétorésistance est de 10 µm. Chaque magnétorésistance occupe ainsi une surface d'un rectangle de 40x60 µm. L'espacement entre les faces en regard de l'aimant 15 et de chacun des aimants 18, 19 est de 100 µm. L'espacement entre les faces en regard de l'aimant 15 et de chacun des aimants 16, 17 est de 440 µm. Les centres géométriques des magnétorésistances sont à mi-distance des 2 aimants qui les polarisent. Les valeurs de polarisation obtenues sont les suivantes pour les magnétorésistances 1, 4 le champ moyen est de 16,46 +/- 0,09 oersteds. Pour les magnétorésistances 2, 3 le champ moyen est de -16,99 +/- 0,19 oersteds. On constate qu'avec cette configuration on obtient un champ très homogène et un pont très bien équilibré.

### Annexe

### liste de documents pertinents de l'art antérieur.

**[1]** Article de Wanjun Ku, Paulo Compadrinho, et Jose Barata intitulé *"Precision X-Y robotic object handling using a dual GMR bridge sensor" (Manipulation X-Y de précision en robotique, par l'utilisation de capteurs utilisant un double pont de magnéto résistances géantes) IEE Transaction on magnetics. Vol 36 N° 5 Septembre 2000.*

## Revendications

1. Structure d'un capteur de champ magnétique formée par des aimants et par un pont de magnétorésistances (1-4), déposés sous forme de couches sur un même substrat (20), les magnétorésistances (1-4), ayant chacune une direction longitudinale, le pont comportant deux magnétorésistances (1,3) ou une paire de magnétorésistances (1,4; 2,3), une première (1) et une seconde (3) magnétorésistances ou une première (1,4) et une seconde (2,3) paires de magnétorésistances, chaque magnétorésistance (1-4) étant polarisée par un ou plusieurs aimants (15-19; 26-29;38,39) ayant chacun deux zones de champ principal d'aimantation, une zone de champ entrant et une zone de champ sortant, alignées selon une direction axiale d'aimantation, et deux zones de champ magnétique de fuite dans lesquelles la direction du champ magnétique est parallèle et de sens opposé à la direction du champ dans les zones de champ principal, la première (1) des deux magnétorésistances (1,3) du pont ou chacune des magnétorésistances (1,4) de la première paire de magnétorésistances du pont étant disposée dans une zone de champ principal d'aimants (15,18,19;28,29; 38,39) et l'autre magnétorésistance (3) ou chacune des magnétorésistances de la deuxième paire (2, 3) de magnétorésistances du pont étant disposée dans une zone de champ de fuite d'aimants (15, 18, 26, 27) de sorte que les deux magnétorésistances (1,3) ou les magnétorésistances (1,4; 2,3) de chaque paire sont polarisées par des champs magnétiques de directions opposées, **caractérisée en ce que** le ou les aimants (15-19 ; 26-29; 38, 39) de polarisation sont au même niveau que les magnétorésistances (1-4) ou ont une légère différence de niveau due à la présence d'une couche, **en ce que** tous les aimants (15-19; 26-29; 38, 39) de polarisation ont une même direction principale d'aimantation contenue dans le plan des couches et en ce gue les magnétorésistances (1-4) du pont ont leur direction longitudinale parallèle à la direction axiale d'aimantation des aimants (15-19; 26-29; 38,39).

2. Structure selon la revendication 1 **caractérisée en ce que** deux (1-4) ou quatre magnétorésistances (1-4) sont réalisées sous forme de un ou plusieurs doigts (12, 12') connectés en série, chaque doigt (12, 12') ayant une direction longitudinale parallèle à la direction principale d'aimantation des aimants (15-19 ; 26-29 ; 38, 39).

3. Structure selon l'une des revendications 1 ou 2 comportant deux paires de magnétorésistances (1, 4; 2, 3), la première paire (1, 4) constituée d'une première et d'une quatrième magnétorésistances et la seconde paire (2, 3) constituée d'une seconde et d'une troisième magnétorésistances **caractérisée en ce que** les magnétorésistances (1-4) sont situées chacune sur une branche d'un quadrilatère, et **en ce que** la polarisation est assurée par un aimant (15) central, les magnétorésistances de la première paire (1, 4) étant situées de part et d'autre de l'aimant central dans les zones de champ principal et les magnétorésistances (2, 3) de la seconde paire étant situées de part et d'autre de l'aimant (15) central dans les zones de champ de fuite.

4. Structure selon la revendication 3 **caractérisée en ce que** la polarisation de deux magnétorésistances (1, 4) polarisés par des champs principaux ou de deux magnétorésistances (2, 3) polarisés par des champs de fuite est assurée en outre par deux aimants supplémentaires (16-19) à l'extérieur du quadrilatère, l'un étant disposé par rapport à l'aimant central, de l'autre côté d'une magnétorésistance (1, 4 ; 2, 3) et l'autre étant disposé par rapport à l'aimant (15) central, de l'autre côté d'une autre magnétorésistance (1, 4; 2, 3).

5. Structure selon la revendication 3 **caractérisée en ce que** la polarisation des magnétorésistances (1-4) est assurée en outre par quatre aimants (16-19) supplémentaires disposés à l'extérieur du quadrilatère, deux des aimants (18, 19) supplémentaires ayant leurs aimantations principales situées sur la même ligne axiale que celle de l'aimant central (15) et les deux autres aimants (16, 17) supplémentaires ayant leurs aimantations principales situées sur des lignes axiales parallèles à celle de l'aimant central, (15) distinctes entre elles et distinctes de la ligne axiale de l'aimant central (15).

6. Structure selon la revendication 2, **caractérisée en ce que** les doigts (12) composant ensemble la première magnétorésistance (1) sont répartis en un premier ensemble de N1 premiers groupes de doigts, **en ce que** les doigts composant ensemble la quatrième magnétorésistance (4) sont répartis en un quatrième ensemble de N4 quatrièmes groupes de doigts, **en ce que** les doigts composant ensemble la deuxième magnétorésistance (2) sont répartis en un deuxième ensemble de N2 deuxièmes groupes de doigts, et **en ce que** les doigts composant ensemble la troisième magnétorésistance (3) sont répartis en un troisième ensemble de N3 troisièmes groupes de doigts, N1, N2, N3, et N4 étant des nombres entiers supérieurs à 1, chacun des premiers groupes de doigts étant placé dans le champ principal d'un (28) ou d'une paire (28, 29) d'aimants distincts en sorte qu'il y a N1 ou 2N1 aimants de polarisation de la première magnétorésistance (1), chacun des quatrièmes groupes de doigts étant placé dans le champ principal d'un (38) ou d'une paire (38, 39) d'aimants distincts en sorte qu'il y a N4 ou 2N4 aimants de polarisation de la quatrième magnétorésistance, chacun des troisièmes groupes de doigts étant placé dans le champ de fuite de deux aimants (26) consécutifs distincts, lesdits aimants (26) consécutifs distincts étant disposés en colonne en sorte qu'il y a (N3 + 1) aimants (26) de polarisation de la troisième magnétorésistance (3), chacun des deuxièmes groupes de doigts étant placé dans le champ de fuite de deux aimants (27) consécutifs distincts, lesdits aimants (27) consécutifs distincts étant disposés en colonne en sorte qu'il y a (N2 + 1) aimants de polarisation de la deuxième magnétorésistance (2).

7. Structure selon la revendication 2,
**caractérisée en ce que** les doigts (12), composant ensemble la première magnétorésistance (1) sont répartis en un premier ensemble de N1 premiers groupes (13-1) de doigts, **en ce que** les doigts (12) composant ensemble la quatrième magnétorésistance (4) sont répartis en un quatrième ensemble de N4 quatrièmes groupes (13-4) de doigts, **en ce que** les doigts (12') composant ensemble la deuxième magnétorésistance (2) sont répartis en un deuxième ensemble de N2 deuxièmes groupes (13'-2) de doigts, et **en ce que** les doigts (12') composant ensemble la troisième magnétorésistance (3) sont répartis en un troisième ensemble de N3 troisièmes groupes (13'-3) de doigts, N1, N2, N3, et N4 étant des nombres entiers supérieurs à 1, les groupes (13-1 ; 13-4) de doigts composant ensemble la première et la quatrième magnétorésistance respectivement étant alignés selon au moins deux colonnes parallèles, des groupes (13-1; 13-4) de doigts de chacune des première et quatrième magnétorésistances (1, 4) respectivement étant répartis en paires, chaque paire comprenant un premier membre et un second membre, le premier membre d'une paire étant situé à la fois dans la zone de champ entrant d'un aimant (25) central et dans la zone de champ sortant d'un premier aimant (29) latéral, le second membre de ladite paire étant situé à la fois dans la zone de champ sortant dudit aimant (25) central et dans la zone de champ entrant d'un second aimant (29') latéral, les premiers (29) et second (29') aimants latéraux et les aimants (25) centraux formant des colonnes parallèles entre elles.

8. Structure selon la revendication 7 **caractérisée en ce que** tous les groupes (13-1 ; 13-4) de doigts (12) composant ensemble la première et la quatrième magnétorésistances (1, 4) respectivement sont répartis en paires en sorte que les nombres N1 et N4 sont des entiers pairs et qu'il y a 3N1/2 aimants (25-1, 29-1, 29'-1) de polarisation de la première magnétorésistance (1) répartis en trois colonnes parallèles comportant chacune au moins N1/2 aimants (25-1, 29-1, 29'-1), et 3N4/2 aimants (25-4, 29-4, 29'-4) de polarisation de la quatrième magnétorésistance (4) répartis en trois colonnes parallèles comportant chacune au moins N4/2 aimants.

9. Structure selon l'une des revendications 7 ou 8 **caractérisée en ce que** des groupes (13'-2 ; 13'-3) de doigts (12') composant ensemble les secondes et troisième magnétorésistances (2, 3) respectivement sont situés dans les zones de champ de fuite de deux aimants (28, 29, 29) consécutifs de colonnes d'aimants latéraux.

10. Structure selon la revendication 9 **caractérisée en ce que** chacun des groupes (13'-2 ; 13'-3) de doigts (12') composant ensemble les secondes et troisième magnétorésistances (2, 3) respectivement est situé de façon isolée dans une zone de champ de fuite de deux aimants consécutifs de colonnes d'aimants (28, 29, 29') latéraux.

11. Structure selon la revendication 2, **caractérisée en ce que** les aimants de polarisation (28, 29, 29') sont répartis de façon matricielle en lignes et colonnes, **en ce que** les doigts (12, 12') composant ensemble chaque magnétorésistance (1-4) sont répartis en groupes (13-1 ; 13-4 ; 13'-2 ; 13'-3) de doigts et **en ce que** des groupes (13-1 ; 13-4) de doigts appartenant à des magnétorésistances (1, 4) polarisées par des champs principaux sont logés dans les zones de champ principal entre aimants de colonnes consécutives appartenant à une même ligne et **en ce que** des groupes de doigts (13'-2 ; 13'-3) appartenant à des magnétorésistances (2, 3) polarisées par des champs de fuite sont logés dans des zones de champ de fuite entre aimants consécutifs appartenant à une même colonne.

12. Structure selon la revendication 11 **caractérisée en ce qu'**elle comporte au moins 3 colonnes d'aimants, réparties en une colonne centrale et deux colonnes latérales, **en ce que** des groupes de doigts logés dans les zones de champ de fuite sont présents uniquement entre aimants consécutifs appartenant aux colonnes latérales.

13. Structure selon la revendication 12 **caractérisée en ce que** l'aimant de la première ligne de la colonne centrale est absent et **en ce que** un groupe de doigts logés dans les zones de champ de fuite entre aimants consécutifs appartenant aux colonnes latérales est présent dans chacun des intervalles entre aimants consécutifs de ces colonnes, et **en ce que** un groupe de doigts appartenant à des magnétorésistances polarisées par des champs principaux est présent entre chacun des intervalles entre aimants consécutifs d'une même ligne à l'exception de la première.

14. Structure selon l'une des revendications 6 à 10 **caractérisée en ce que** les nombres entier N1 et N3 sont égaux entre eux et les nombres N4 et N2 sont égaux entre eux également, **en ce que** les colonnes d'aimants latéraux de polarisation de la première magnétorésistance comportent chacune (N1/2 + 1) aimants, les colonnes d'aimants latéraux de polarisation de la quatrième magnétorésistance comportent chacune (N4/2 + 1) aimants et **en ce que** tout les groupes de doigts composant ensemble la seconde magnétorésistance sont chacun situés de façon isolée dans une zone de champ de fuite de deux aimants consécutifs appartenant à des colonnes latérales de polarisation de la quatrième magnétorésistance, et **en ce que** tout les groupes de doigts composant ensemble la troisième magnétorésistance sont chacun situés de façon isolée dans une zone de champ de fuite de deux aimants consécutifs appartenant à des colonnes latérales d'aimants de polarisation de la première magnétorésistance.

15. Structure selon la revendication 6, **caractérisée en ce que** N1 est égal à N4 et **en ce que** N2 est égal à N3.

16. Structure selon l'une des revendications 6 à 10 ou des revendications 14, 15, **caractérisée en ce que** N1, N2, N3, et N4 sont égaux entre eux.

17. Structure selon l'une des revendications 1 à 16 **caractérisée en ce que** les aimants (15-19 ; 26-29 ; 38, 39) ont selon une section parallèle au plan des couches, des formes rectangulaires le champ principal entrant et sortant par des faces (6, 7) de flux principal et les champs de fuite étant situées de part et d'autre de faces (8, 9) de fuite, les faces (6, 7) de flux principal étant perpendiculaires aux faces (8, 9) de fuite, les zones de champ principal de chaque aimant étant centrées sensiblement sur un axe central des faces (6, 7) de flux principal dudit aimant, les zones de champ de fuite dudit aimant étant centrées sensiblement sur un axe central des faces (8, 9) de fuite.

18. Capteur comportant une structure selon l'une des revendications 1 à 17.

## Claims

1. Structure of a magnetic field sensor formed by magnets and by a bridge of magnetoresistors (1-4), arranged in the form of layers deposited on the same substrate (20), the magnetoresistors (1-4) each having a longitudinal direction, the bridge comprising two magnetoresistors (1, 3) or a pair of magnetoresistors (1, 4; 2, 3), a first (1) and a second (3) magnetoresistor or a first (1, 4) and a second (2, 3) pair of magnetoresistors, each magnetoresistor (1-4) being polarised by one or more magnets (15-19; 26-29; 38, 39), each having two areas of main field of magnetisation, one area of inlet field and one area of outlet field, aligned according to an axial direction of magnetisation, and two magnetic leakage field areas in which the direction of the magnetic field is parallel and in the opposite direction to the direction of the field in the areas of the main field, the first (1) of the two magnetoresistors (1, 3) of the bridge or each of the magnetoresistors (1, 4) of the first pair of magnetoresistors of the bridge being arranged in an area of the main field of magnets (15, 18, 19; 28, 29; 38, 39) and the other magnetoresistor (3) or each of the magnetoresistors of the second pair (2, 3) of magnetoresistors of the bridge being arranged in a leakage field of magnets (15, 18, 26, 27) in such a way that the two magnetoresistors (1, 3) or the magnetoresistors (1, 4; 2, 3) of each pair are polarised by the magnetic fields of opposite directions, **characterised in that** the magnet(s) (15-19; 26-29; 38, 39) of polarisation are at the same level as the magnetoresistors (1-4) or have a slight difference in level due to the presence of a layer, **in that** all the magnets (15-19; 26-29; 38, 39) of polarisation have a same main direction of magnetisation contained in the plane of the layers, and **in that** the magnetoresistors (1-4) of the bridge have their longitudinal direction parallel to the axial direction of magnetisation of the magnets (15-19; 26-29; 38, 39).

2. Structure according to Claim 1, **characterised in that** two (1-4) or four magnetoresistors (1-4) are arranged in the form of one or more fingers (12, 12') connected in series, each finger (12, 12') having a longitudinal direction parallel to the main direction of magnetisation of the magnets (15-19; 26-29; 38, 39).

3. Structure according to one of Claims 1 or 2, comprising two pairs of magnetoresistors (1,4; 2, 3), the first pair (1, 4) consisting of a first and a fourth magnetoresistor and the second pair (2, 3) consisting of a second and a third magnetoresistor, **characterised in that** the magnetoresistors (1-4) are each located on a branch of a quadrilateral, and **in that** the polarisation is ensured by a central magnet (15), the magnetoresistors of the first pair (1, 4) being located on one side and the other of the central magnet in the areas of the main field, and the magnetoresistors (2, 3) of the second pair being located on one side and the other of the central magnet (15) in the areas of the leakage field.

4. Structure according to Claim 3, **characterised in that** the polarisation of two magnetoresistors (1, 4) polarised by the main fields or of two magnetoresistors (2, 3) polarised by the leakage fields is also ensured by two supplementary magnets (16-19) on the outside of the quadrilateral, one being arranged in relation to the central magnet on the other side of a magnetoresistor (1, 4; 2, 3) and the other being arranged in relation to the central magnet (15) on the other side of another magnetoresistor (1, 4; 2, 3).

5. Structure according to Claim 3, **characterised in that** the polarisation of the magnetoresistors (1-4) is also ensured by four supplementary magnets (16-19) arranged on the outside of the quadrilateral, two of the supplementary magnets (18, 19) having their areas of main field of magnetisation located on the same axial line as that of the central magnet (15) and the two other supplementary magnets (16, 17) having their areas of main field of magnetisation located on the axial lines parallel to that of the central magnet (15), distinct from one another and distinct from the axial line of the central magnet (15).

6. Structure according to Claim 2, **characterised in that** the fingers (12) which together form the first magnetoresistor (1) are distributed according to a first set of N1 first groups of fingers, **in that** the fingers which together form the fourth magnetoresistor (4) are distributed according to a fourth set of N4 fourth groups of fingers, **in that** the fingers which together form the second magnetoresistor (2) are distributed according to a second set of N2 second groups of fingers, and **in that** the fingers which together form the third magnetoresistor (3) are distributed according to a third set of N3 third groups of fingers, N1, N2, N3, and N4 being integers greater than 1, each of the first groups of fingers being located in the main field of one (28) or of a pair (28, 29) of distinct magnets, in such a way that there are N1 or 2N1 polarisation magnets of the first magnetoresistor (1), each of the four groups of fingers being located in the principal field of one (38) or of a pair (38, 39) of distinct magnets, in such a way that there are N4 or 2N4 polarisation magnets of the fourth magnetoresistor, each of the third groups of fingers being located in the leakage field of two distinct and consecutive magnets (26), said distinct and consecutive magnets (26) being arranged in a column in such a way that there are (N3 + 1) polarisation magnets (26) of the third magnetoresistor (3), each of the second groups of fingers being located in the leakage field of two distinct and consecutive magnets (27), said distinct and consecutive magnets (27) being arranged in a column in such a way that there are (N2 + 1) polarisation magnets of the second magnetoresistor (2).

7. Structure according to Claim 2, **characterised in that** the fingers (12) which together form the first magnetoresistor (1) are distributed according to a first set of N1 first groups (13-1) of fingers, **in that** the fingers (12) which together form the fourth magnetoresistor (4) are distributed according to a fourth set of N4 fourth groups (13-4) of fingers, **in that** the fingers (12') which together form the second magnetoresistor (2) are distributed according to a second set of N2 second groups (13'-2) of fingers, and **in that** the fingers (12') which together form the third magnetoresistor (3) are distributed according to a third set of N3 third groups (13'-3) of fingers, N1, N2, N3 and N4 being integers greater than 1, the groups (13-1; 13-4) of fingers which together form the first and fourth magnetoresistors respectively being aligned in at least two parallel columns, groups (13-1; 13-4) of fingers of each of the first and fourth magnetoresistors (1, 4) respectively being divided into pairs, each pair comprising a first member and a second member, the first member of a pair being located at the same time in the inlet field of a central magnet (25) and in the outlet field of a first lateral magnet (29), the second member of said pair being located at the same time in the outlet field of said central magnet (25) and in the inlet field of a second lateral magnet (29'), the first (29) and second (29') lateral magnets and the central magnets (25) forming columns parallel to each other.

8. Structure according to Claim 7, **characterised in that** all the groups (13-1; 13-4) of fingers (12) which together form the first and fourth magnetoresistors (1, 4) respectively are distributed according to pairs in such a way that the numbers N1 and N4 are even integers and that there are 3N1/2 polarisation magnets (25-1, 29-1, 29'-1) of the first magnetoresistor (1) distributed according to three parallel columns, each comprising at least N1/2 magnets (25-1, 29-1, 29'-1) and 3N4/2 polarisation magnets (25-4, 29-4, 29'-4) of the fourth magnetoresistor (4) distributed according to three parallel columns comprising at least N4/2 magnets.

9. Structure according to one of Claims 7 or 8, **characterised in that** the groups (13'2; 13'-3) of fingers (12') which together form the second and third magnetoresistors (2, 3) respectively are located in the leakage areas of two consecutive magnets (28, 29, 29) of columns of lateral magnets.

10. Structure according to Claim 9, **characterised in that** each of the groups (13'2; 13'-3) of fingers (12') which together form the second and third magnetoresistors (2, 3) respectively are located in an isolated fashion in an area of the leakage field of two consecutive magnets of lateral columns of magnets (28, 29, 29').

11. Structure according to Claim 2, **characterised in that** the polarisation magnets (28, 29, 29') are divided in matrix fashion into lines and columns, **in that** the fingers (12, 12') which together form each magnetoresistor (1-4) are divided into groups (13-1; 13-4; 13'-2; 13'-3) of fingers, and **in that** groups (13-1; 13-4) of fingers belonging to magnetoresistors (1, 4) polarised by the main fields are located in the areas of the main field between magnets of consecutive columns belonging to a same line, and **in that** groups of fingers (13'-2; 13'-3) belonging to magnetoresistors (2, 3) polarised by leakage fields are located in areas of leakage fields between consecutive magnets belonging to the same column.

12. Structure according to Claim 11, **characterised in that** it comprises at least 3 columns of magnets, distributed according to one central column and two lateral columns, **in that** groups of fingers located in the leakage field areas are present solely between consecutive magnets belonging to lateral columns.

13. Structure according to Claim 12, **characterised in that** the magnet of the first raw of the central column is absent and **in that** a group of fingers located in leakage field areas between consecutive magnets belonging to the lateral columns is present in each of the intervals between consecutive magnets of these columns, and **in that** a group of fingers belonging to magnetoresistors polarised by main fields is present between each of the intervals between consecutive magnets of a same line, with the exception of the first.

14. Structure according to one of Claims 6 to 10, **characterised in that** the integers N1 and N3 are equal to one another and the numbers N4 and N2 are likewise equal to one another, **in that** the columns of lateral polarisation magnets of the first magnetoresistor each comprise (N1/2 + 1) magnets, the lateral columns of polarisation magnets of the fourth magnetoresistor each comprise (N4/2 + 1) magnets and **in that** all the groups of fingers which together form the second magnetoresistor are each located in an isolated manner in a leakage field area of two consecutive magnets belonging to lateral polarisation columns of the fourth magnetoresistor, and **in that** all the groups of fingers which together form the third magnetoresistor are each located in an isolated manner in a leakage field area of two consecutive magnets belonging to lateral columns of polarisation magnets of the first magnetoresistor.

15. Structure according to Claim 6, **characterised in that** N1 is equal to N4 and **in that** N2 is equal to N3.

16. Structure according to one of Claims 6 to 10 or of Claims 14, 15, **characterised in that** N1, N2, N3 and N4 are equal to one another.

17. Structure according to one of Claims 1 to 16, **characterised in that** the magnets (15-19; 26-29; 38, 39) have, according to a cross section parallel to the plane of the layers, rectangular shapes, the main field entering and leaving via the faces (6, 7) of main flux and the leakage fields being located on one side and the other of leakage faces (8, 9), the faces (6, 7) of main flux being perpendicular to the leakage faces (8, 9), the areas of the main field of each magnet being substantially centred on a central axis of the faces (6, 7) of main flux of said magnet, the leakage field areas of said magnet being substantially centred on a central axis of the leakage faces (8, 9).

18. Sensor comprising a structure according to one of Claims 1 to 17.

## Patentansprüche

1. Struktur eines Magnetfeldsensors, gebildet durch Magnete und durch eine Brücke von Magnetowiderständen (1-4), abgeschieden auf einem selben Substrat (20) in Form von Schichten, wobei jeder der Magnetowiderstände (1-4) eine Längsrichtung hat, die Brücke zwei Magnetowiderstände (1,3) oder ein Paar Magnetowiderstände (1,4; 2,3) umfasst, einen ersten (1) und einen zweiten (3) Magnetowiderstand oder ein erstes (1,4) und ein zweites (2,3) Paar Magnetowiderstände, wobei jeder Magnetowiderstand (1-4) polarisiert wird durch einen oder mehrere Magnete (15-19; 26-29; 38, 39), von denen jeder zwei Magnetisierungshauptfeldzonen aufweist, eine Eintrittsfeldzone und eine Austrittsfeldzone, ausgerichtet gemäß einer axialen Magnetisierungsrichtung, und zwei magnetische Streufeldzonen, in denen die Richtung des Magnetfelds parallel ist und entgegengesetzt zu der Richtung des Felds in den Hauptfeldzonen, wobei der erste (1) der beiden Magnetowiderstände (1,3) der Brücke oder jeder der Magnetowiderstände (1,4) des ersten Magnetowiderständepaars der Brücke in einer Hauptfeldzone von Magneten (15,18,19; 28,29; 38,39) angeordnet ist, und der andere Magnetowiderstand (3) oder jeder der Magnetowiderstände des zweiten Paars (2, 3) von Magnetowiderständen der Brücke in einer Streufeldzone von Magneten (15, 18, 26, 27) angeordnet ist, so dass die beiden Magnetowiderstände (1,3) oder die Magnetowiderstände (1,4; 2,3) jedes Paars durch Magnetfelder mit entgegengesetzten Richtungen polarisiert werden, **dadurch gekennzeichnet, dass** der oder die Polarisationsmagnete (15-19; 26-29; 38, 39) sich auf dem selben Niveau wie die Magnetowiderstände (1-4) befinden oder aufgrund des Vorhandenseins einer Schicht eine geringe Niveaudifferenz aufweisen, und dadurch, dass die Polarisationsmagnete (15-19; 26-29; 38, 39) eine selbe in der Ebene der Schichten enthaltene Magnetisierungshauptrichtung haben, und dadurch, dass die Magnetowiderstände (1-4) der Brücke eine Längsrichtung parallel zu der axialen Magnetisierungsrichtung der Magnete (15-19; 26-29; 38, 39) haben.

2. Struktur nach Anspruch 1, **dadurch gekennzeichnet, dass** zwei (1-4) oder vier Magnetowiderstände (1-4) in Form von einem oder mehreren seriengeschalteten Fingern (12, 12') realisiert sind, wobei jeder Finger (12, 12') eine zu der Hauptmagnetisierungsrichtung der Magnete (15-19; 26-29; 38, 39) parallele Längsrichtung hat.

3. Struktur nach einem der Ansprüche 1 oder 2 mit zwei Magnetowiderstandspaaren (1, 4; 2, 3), dem ersten Paar (1, 4), gebildet durch einen ersten und einen vierten Magnetowiderstand, und dem zweiten Paar (2, 3), gebildet durch einen zweiten und einen dritten Magnetowiderstand, **dadurch gekennzeichnet, dass** jeder der Magnetowiderstände (1-4) sich in jeweils einem der Zweige eines Vierecks befindet, und dadurch, dass die Polarisation durch einen zentralen Magnet (15) erfolgt, wobei die Magnetowiderstände des ersten Paars (1, 4) sich beiderseits des zentralen Magnets in den Hauptfeldzonen befinden, und die Magnetowiderstände (2-3) des zweiten Paars sich beiderseits des zentralen Magnets (15) in den Streufeldzonen befinden.

4. Struktur nach Anspruch 3, **dadurch gekennzeichnet, dass** die Polarisation von zwei durch Hauptfelder polarisierten Magnetowiderständen (1, 4) oder die Polarisation von zwei durch Streufelder polarisierten Magnetowiderständen (2, 3) außerdem durch zwei zusätzliche Magnete (16-19) erfolgt, die sich außerhalb des Vierecks befinden, wobei der eine sich in Bezug auf den zentralen Magnet auf der anderen Seite eines Magnetowiderstands (1, 4; 2, 3) befindet, und der andere sich in Bezug auf den zentralen Magnet (15) auf der anderen Seite eines anderen Magnetowiderstands (1, 4; 2, 3) befindet.

5. Struktur nach Anspruch 3, **dadurch gekennzeichnet, dass** die Polarisation der Magnetowiderstände (1-4) außerdem durch vier außerhalb des Vierecks angeordnete zusätzliche Magnete (16-19) erfolgt, wobei die Hauptmagnetisierungen von zwei der zusätzlichen Magnete (18, 19) sich auf derselben axialen Linie befinden wie diejenige des zentralen Magnets (15), und die Hauptmagnetisierungen der beiden anderen zusätzlichen Magnete (16, 17) sich auf axialen Linien befinden, die parallel sind zu der des zentralen Magnets (15), verschieden voneinander und verschieden von der axialen Linie des zentralen Magnets (15).

6. Struktur nach Anspruch 2, **dadurch gekennzeichnet, dass** die Finger (12), die zusammen den ersten Magnetowiderstand (1) bilden, in einer ersten Einheit von N1 ersten Gruppen von Fingern verteilt sind, und dadurch, dass die Finger, die zusammen den vierten Magnetowiderstand (4) bilden, in einer vierten Einheit von N4 vierten Gruppen von Fingern verteilt sind, und dadurch, dass die Finger, die zusammen den zweiten Magnetowiderstand (2) bilden, in einer zweiten Einheit von N2 zweiten Gruppen von Fingern verteilt sind, und dadurch, dass die Finger, die zusammen den dritten Magnetowiderstand (3) bilden, in einer dritten Einheit von N3 dritten Gruppen von Fingern verteilt sind, wobei N1, N2, N3 und N4 ganze Zahlen größer als 1 sind, jede der ersten Gruppen von Fingern sich in dem Hauptfeld eines Magnets (28) oder eines Paars verschiedener Magnete (28, 29) befindet, so dass es N1 oder 2N1 Polarisationsmagnete des ersten Magnetowiderstands (1) gibt, jede der vierten Gruppen von Fingern sich in dem Hauptfeld eines Magnets (38) oder eines Paars verschiedener Magnete (38, 39) befindet, so dass es N4 oder 2N4 Polarisationsmagnete des vierten Magnetowiderstands gibt, wobei jede der drei Gruppen von Fingern sich in dem Streufeld von zwei verschiedenen aufeinanderfolgenden Magneten (26) befindet, die spaltenförmig angeordnet sind, so dass es (N3 + 1) Polarisationsmagnete (26) des dritten Magnetowiderstands (3) gibt, jede der zweiten Gruppen von Fingern sich in dem Streufeld von zwei verschiedenen aufeinanderfolgenden Magneten (27) befindet, und die verschiedenen genannten aufeinanderfolgenden Magnete (27) spaltenförmig angeordnet sind, so dass es (N2 + 1) Polarisationsmagnete des zweiten Magnetowiderstands (2) gibt.

7. Struktur nach Anspruch 2, **dadurch gekennzeichnet, dass** die Finger (12), die zusammen den ersten Magnetowiderstand (1) bilden, in einer ersten Einheit von N1 ersten Gruppen (13-1) von Fingern verteilt sind, und dadurch, dass die Finger (12), die zusammen den vierten Magnetowiderstand (4) bilden, in einer vierten Einheit von N4 vierten Gruppen (13-4) von Fingern verteilt sind, und dadurch, dass die Finger (12'), die zusammen den zweiten Magnetowiderstand (2) bilden, in einer zweiten Einheit von N2 zweiten Gruppen (13'-1) von Fingern verteilt sind, und dadurch, dass die Finger (12°), die zusammen den dritten Magnetowiderstand (3) bilden, in einer dritten Einheit von N3 dritten Gruppen (13'-1) von Fingern verteilt sind, wobei N1, N2, N3 und N4 ganze Zahlen größer als 1 sind, die Gruppen (13-1; 13-4) von Fingern, die zusammen jeweils den ersten und den vierten Magnetowiderstand bilden, entsprechend wenigstens zwei parallelen Spalten ausgerichtet sind, Gruppen (13-1; 13-4) von Fingern des ersten und vierten Magnetowiderstands (1, 4) jeweils paarweise verteilt sind, jedes Paar ein erstes und zweites Glied umfasst, das erste Glied eines Paars sich zugleich in der Eintrittsfeldzone eines zentralen Magnets (25) und in der Austrittsfeldzone eines ersten seitlichen Magnets (29) befindet, das zweite Glied des genannten Paars sich zugleich in der Austrittsfeldzone eines genannten zentralen Magnets (25) und in der Eintrittsfeldzone eines zweiten seitlichen Magnets (29') befindet, wobei die ersten (29) und zweiten (29') seitlichen Magnete und die zentralen Magnete (25) zueinander parallele Spalten bilden.

8. Struktur nach Anspruch 7, **dadurch gekennzeichnet, dass** alle Gruppen (13-1; 13-4) von Fingern (12), die zusammen den ersten und den vierten Magnetowiderstand (1, 4) bilden, paarweise so verteilt sind, dass die Zahlen N1 und N4 gerade Ganzzahlen sind, und dass es 3N1/2 Polarisationsmagnete (25-1, 29-1, 29'-1) des ersten Magnetowiderstands (1), verteilt auf drei parallele Spalten, jede wenigstens N1/2 Magnete (25-1, 29-1, 29'-1) umfassend, und 3N4/2 Polarisationsmagnete (25-4, 29-4, 29'-4) des vierten Magnetowiderstands (4), verteilt auf drei parallele Spalten, jede wenigstens N4/2 Magnete umfassend, gibt.

9. Struktur nach einem der Ansprüche 7 oder 8, **dadurch gekennzeichnet, dass** die Gruppen (13'-2; 13'-3) von Fingern (12'), die zusammen die zweiten und dritten Magnetowiderstände (2, 3) bilden, sich in den Streufeldzonen von zwei aufeinanderfolgenden Magneten (28, 29, 29) von Spalten seitlicher Magnete befinden.

10. Struktur nach Anspruch 9, **dadurch gekennzeichnet, dass** jede der Gruppen (13'-2; 13'-3) von Fingern (12'), die zusammen die zweiten und dritten Magnetowiderstände (2, 3) bilden, sich auf isolierte Weise in einer Streufeldzone von zwei aufeinanderfolgenden Magneten von Spalten seitlicher Magnete (28, 29, 29') befinden.

11. Struktur nach Anspruch 2, **dadurch gekennzeichnet, dass** die Polarisationsmagnete (28, 29, 29') matrixartig zeilen- und spaltenförmig verteilt sind, und dadurch, dass die Finger (12, 12'), die zusammen jeden Magnetowiderstand (1-4) bilden, in Gruppen (13-1; 13-4; 13'-2; 13'3) von Fingern verteilt sind, und dadurch, dass Gruppen (13-1; 13-4) von Fingern, die zu durch Hauptfelder polarisierten Magnetowiderständen (1, 4) gehören, sich in den Hauptfeldzonen zwischen zu einer selben Zeile gehörenden Magneten aufeinanderfolgender Spalten befinden, und dadurch dass Gruppen von Fingern (13'-2; 13'-3), die zu durch Streufelder polarisierten Magnetowiderständen (2, 3) gehören, sich in Streufeldzonen zwischen zu einer selben Spalte gehörenden aufeinanderfolgenden Magneten befinden.

12. Struktur nach Anspruch 11, **dadurch gekennzeichnet, dass** sie wenigstens 3 Magnetspalten umfasst, verteilt auf eine zentrale Spalte und zwei seitliche Spalten, und dadurch, dass in den Streufeldzonen befindliche Gruppen von Fingern nur zwischen aufeinanderfolgenden Magneten der seitlichen Spalten vorhanden sind.

13. Struktur nach Anspruch 12, **dadurch gekennzeichnet, dass** der Magnet der ersten Zeile der zentralen Spalte fehlt, und dadurch, dass eine Gruppe von Fingern, in den Streufeldzonen zwischen zu den seitlichen Spalten gehörenden aufeinanderfolgenden Magneten befindlich, in jedem der Intervalle zwischen aufeinanderfolgenden Magneten dieser Spalten vorhanden ist, und dadurch, dass eine Gruppe von Fingern, die zu durch Hauptfelder polarisierten Magnetowiderständen gehören, zwischen jedem der Intervalle zwischen aufeinanderfolgenden Magneten einer selben Spalte, mit Ausnahme der ersten, vorhanden ist.

14. Struktur nach einem der Ansprüche 6 bis 10, **dadurch gekennzeichnet, dass** die ganzen Zahlen N1 und N3 untereinander gleich sind und die Zahlen N4 und N2 ebenfalls untereinander gleich sind, und dadurch, dass jede der seitlichen Polarisationsmagnetspalten des ersten Magnetowiderstands (N1/2 + 1) Magnete umfasst, jede der seitlichen Polarisationsmagnetspalten (N4/2 + 1) Magnete umfasst, und dass alle Gruppen von Fingern, die zusammen den zweiten Magnetowiderstand bilden, in einer Streufeldzone von zwei aufeinanderfolgenden Magneten isoliert sind, die zu seitlichen Polarisationsspalten bzw. Polarisationsmagnetspalten des vierten Magnetowiderstands gehören, und dadurch, dass jede der Gruppen von Fingern, die zusammen den dritten Magnetowiderstand bilden, sich isoliert in einer Streufeldzone von zwei aufeinanderfolgenden Magneten befindet, die zu seitlichen Polarisationsmagnetspalten des ersten Magnetowiderstands gehören.

15. Struktur nach Anspruch 6, **dadurch gekennzeichnet, dass** N1 gleich N4 ist und N2 gleich N3 ist.

16. Struktur nach einem der Ansprüche 6 bis 10 oder den Ansprüchen 14, 15, **dadurch gekennzeichnet, dass** N1, N2, N3 und N4 untereinander gleich sind.

17. Struktur nach einem der Ansprüche 1 bis 16, **dadurch gekennzeichnet, dass** die Magnete (15-19; 26-29; 38, 39) gemäß einem zu der Ebene der Schichten parallelen Querschnitt rechteckige Formen haben, das Hauptfeld durch Hauptflussflächen (6, 7) eintritt und austritt und die Streufelder sich beiderseits von Streuflächen (8, 9) befinden, wobei die Hauptflussflächen (6, 7) zu den Streuflächen (8, 9) senkrecht sind, die Hauptfeldzonen jedes Magnets im Wesentlichen auf eine Mittelachse der Flächen (6, 7) des Hauptflusses des genannten Magneten zentriert sind und die Streufeldzonen des genannten Magneten im Wesentlichen auf eine Mittelachse der Streuflächen (8, 9) zentriert sind.

18. Sensor der eine Struktur nach einem der Ansprüche 1 bis 17 umfasst.
